(19) **Europäisches Patentamt**
**European Patent Office**
**Office européen des brevets**

(11) **EP 4 675 669 A1**

(12) **EUROPÄISCHE PATENTANMELDUNG**

(43) Veröffentlichungstag:
07.01.2026 Patentblatt 2026/02

(51) Internationale Patentklassifikation (IPC):
*H01J 37/32* (2006.01) *C23C 14/32* (2006.01)

(21) Anmeldenummer: 25186533.3

(52) Gemeinsame Patentklassifikation (CPC):
**H01J 37/32055; C23C 14/325**

(22) Anmeldetag: 01.07.2025

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**
Benannte Erstreckungsstaaten:
**BA**
Benannte Validierungsstaaten:
**GE KH LA MA MD TN**

(30) Priorität: 04.07.2024 DE 102024118984

(71) Anmelder: **VON ARDENNE Asset GmbH & Co. KG**
**01328 Dresden (DE)**

(72) Erfinder:
• **Martin, Kopte**
**01705 Freital (DE)**
• **Ruben, Seifert**
**01277 Dresden (DE)**
• **Wenzel, Marc Tobias**
**01309 Dresden (DE)**

(54) **BESCHICHTUNGSSYSTEM, ELEKTRISCHEN GENERATOR, LEISTUNGSVERSORGUNG UND VERWENDUNG DESSEN**

(57) Gemäß verschiedenen Ausführungsformen weist ein Beschichtungssystem zum Beschichten eines Substrats mittels einer Bogenentladung auf: ein Targethalter (112h) zum Halten eines Targets; einen entlang einer Emissionsachse (111) hinter dem Targethalter (112h) angeordneten Substrathalter (104) zum Halten eines mittels des Targets (112h) zu beschichtenden Substrats; eine Anode (132) zum Erzeugen einer Bogenentladung zwischen dem Targethalter (112h) und der Anode (132), wobei die Anode (132) zwischen dem Targethalter (112h) und dem Substrathalter (104) angeordnet ist; ein entlang der Emissionsachse (111) hinter der Anode (132) angeordnetes Stellsystem (134), welches eingerichtet ist, ein elektrisches und/oder magnetisches Feld zu erzeugen zum Beeinflussen eines mittels der Bogenentladung sich von dem Targethalter (112h) entlang der Emissionsachse (111) ausbreitenden Plasmas.

**FIG. 1A**

100a

**Beschreibung**

Verschiedene Ausführungsbeispiele betreffen ein Beschichtungssystem, einen elektrischen Generator, eine Leistungsversorgung und eine Verwendung dessen.

Im Allgemeinen kann ein Substrat (z.B. ein Werkstück) beschichtet werden, so dass die chemischen und/oder physikalischen Eigenschaften des Substrats verändert werden können. Das Beschichten des Substrats kann in einem Vakuum erfolgen, in welchem eine Schicht oder mehrere Schichten als Beschichtung mittels einer physikalischen Gasphasenabscheidung auf dem Substrat abgeschieden werden, wovon das sogenannte Lichtbogenverdampfen ein etablierter Vertreter ist. Beim Lichtbogenverdampfen wird das Beschichtungsmaterial mittels einer Lichtbogenentladung in die gasförmige Phase überführt, welches aufgrund der hohen Energien zumindest teilweise ionisiert ist, d.h. als Plasma vorliegt.

Hierbei bestehen allerdings noch immer Hürden, welche es erschweren, hohe Anforderungen an das Resultat des Lichtbogenverdampfens zu erreichen. Zu diesen Anforderungen gehören unter anderem die Gleichmäßigkeit der Beschichtung, welche unter anderem eine Funktion der Ausbreitung des gasförmigen Beschichtungsmaterials ist im Raum ist (auch als Ausbreitungscharakteristik bezeichnet).

Gemäß verschiedenen Ausführungsformen wurde anschaulich erkannt, dass zusätzlicher Spielraum besteht zum Beeinflussen des Lichtbogenverdampfens. Genauer gesagt wurde erkannt, dass der mehrdimensionale Zustandsraum des Plasmas bisher nur unvollständig adressiert wurde. Verschiedene Eigenschaften des Plasmas, welche den mehrdimensionalen Zustandsraum des Plasmas aufspannen, sind beispielsweise Störungen und/oder Variationen unterworfen, welche bisher nur ungenügend (z.B. ungenau) oder gar nicht kompensiert werden können. Beispiele für solche Eigenschaften weisen unter anderem die Zusammensetzung des Plasmas (z.B. Ionisationsgrad und/oder Zusammensetzung elektrisch geladener Bestandteile des Plasmas), Rate und/oder räumliche Ausbreitungscharakteristik des Plasmas.

Gemäß verschiedenen Ausführungsformen wird die sich daraus ergebende Erkenntnis adressiert mittels eines zusätzlichen Stellsystems, welches den Zugriff auf den Zustandsraum des Plasmas erweitert, insbesondere zum Beeinflussen des Plasmas (z.B. dessen Arbeitspunkt). Hierzu wird eine dazu passende Verschaltung zum Bereitstellen eines oder mehr als eines Generators bereitgestellt, welche es erleichtert, den so erweiterten Zugriff auf den Zustandsraum des Plasmas auch auszuschöpfen.

Im Folgenden werden verschiedene Beispiele beschrieben, die sich auf hierin Beschriebene und in den Figuren Dargestellte beziehen.

Beispiel 1 ist eingerichtet gemäß einem der beigefügten Ansprüche und/oder ist ein Beschichtungssystem zum Beschichten eines Substrats mittels einer Lichtbogenentladung (kurz auch als Bogenentladung bezeichnet), aufweisend: ein Target (oder zumindest einen Targethalter); einen entlang einer Emissionsachse (z.B. in Emissionsrichtung) hinter dem Target (oder zumindest dem Targethalter) angeordneten Substrathalter zum Halten eines mittels des Targets zu beschichtenden Substrats; eine Anode zum Erzeugen der zwischen dem Target (oder zumindest dem Targethalter) und der Anode vermittelten Bogenentladung, wobei die Anode zwischen dem Target (oder zumindest dem Targethalter) und dem Substrathalter angeordnet ist; ein entlang der Emissionsachse (z.B. Emissionsrichtung) hinter der Anode angeordnetes Stellsystem, welches eingerichtet ist, ein (z.B. gepulstes) elektrisches Feld und/oder magnetisches Feld zu erzeugen zum Beeinflussen eines mittels der Bogenentladung sich von dem Target entlang der Emissionsachse (z.B. Emissionsrichtung) ausbreitenden Plasmas (z.B. dessen räumlicher Verteilung).

Beispiel 2 (z.B. ein Beschichtungssystem) ist eingerichtet gemäß Beispiel 1, wobei das Stellsystem ein kapazitives Stellglied (z.B. eine Elektrode) zum Erzeugen des elektrischen Feldes und/oder ein induktives Stellglied (z.B. einen Elektromagneten) zum Erzeugen des magnetischen Feldes aufweist, welche entlang Emissionsachse (z.B. in Emissionsrichtung) hinter der Anode angeordnet sind.

Beispiel 3 (z.B. ein Beschichtungssystem) ist eingerichtet gemäß Beispiel 1 oder 2, wobei das Stellsystem (z.B. dessen induktives Stellglied) eine oder mehr als eine elektromagnetischen Spule aufweist, vorzugsweise zwei Spulen, welche entlang der Emissionsachse (z.B. in Emissionsrichtung) hintereinander angeordnet sind.

Beispiel 4 (z.B. ein Beschichtungssystem) ist eingerichtet gemäß einem der Beispiele 1 bis 3, wobei das das Stellsystem (z.B. dessen induktives Stellglied und/oder jede Spule davon) eine oder mehr als eine Windung aufweist, welche die Emissionsachse umläuft.

Beispiel 5 (z.B. ein Beschichtungssystem) ist eingerichtet gemäß einem der Beispiele 1 bis 4, wobei das das Stellsystem (z.B. dessen induktives Stellglied und/oder jede Spule davon) eine Spulenachse aufweist, die parallel zur Emissionsachse (z.B. Emissionsrichtung) ist, z.B. mit dieser zusammenfällt (diese berührend).

Beispiel 6 (z.B. ein Beschichtungssystem) ist eingerichtet gemäß einem der Beispiele 1 bis 5, wobei das Stellsystem (z.B. dessen kapazitives Stellglied und/oder jede Elektrode davon) entlang der Emissionsachse (z.B. Emissionsrichtung) von einer Durchgangsöffnung (auch als Passage bezeichnet) durchdrungen ist, das Stellsystem z.B. mehrere (z.B. balkenförmige) Komponenten (z.B. Träger) aufweisend, welche die Durchgangsöffnung begrenzen.

Beispiel 7 (z.B. ein Beschichtungssystem) ist eingerichtet gemäß einem der Beispiele 1 bis 6, wobei das Stellsystem (z.B. dessen kapazitives Stellglied und/oder jede Elektrode davon) rahmenförmig ist.

Beispiel 8 (z.B. ein Beschichtungssystem) ist eingerichtet gemäß einem der Beispiele 1 bis 7, wobei das Stellsystem (z.B. dessen kapazitives Stellglied und/oder jede Elektrode davon) und/oder die Passage eine größere Ausdehnung (oder Querschnittsfläche quer zur Emissionsachse) aufweist als die Anode (z.B. entlang einer oder mehr als einer quer zu der Emissionsachse (z.B. Emissionsrichtung) verlaufenden Richtung (z.B. eine Gravitationsrichtung aufweisend), wovon zwei Richtungen beispielsweise quer zueinander sind.

Beispiel 9 (z.B. ein Beschichtungssystem) ist eingerichtet gemäß einem der Beispiele 1 bis 8, wobei das Stellsystem (z.B. dessen kapazitives Stellglied und/oder jede Elektrode davon) ein oder mehr als ein Paar (z.B. balkenförmiger) Komponenten (z.B. Balken) aufweist, zwischen denen die Emissionsachse (z.B. Emissionsrichtung) hindurch verläuft, welche einen Abstand entlang einer oder mehr als einer quer zu der Emissionsachse (z.B. Emissionsrichtung) verlaufenden Richtung voneinander aufweisen, der größer ist als eine Ausdehnung des Targets (oder zumindest dem Targethalter) und/oder des Substrathalters (oder zumindest dessen Aufnahmebereich) entlang der Richtung.

Beispiel 10 (z.B. ein Beschichtungssystem) ist eingerichtet gemäß einem der Beispiele 1 bis 9, wobei das Stellsystem (z.B. dessen kapazitives Stellglied und/oder jede Elektrode davon) ein oder mehr als ein Paar (z.B. balkenförmiger) Komponenten (z.B. Balken) aufweist, zwischen denen die Emissionsachse (z.B. Emissionsrichtung) hindurch verläuft, welche einen größeren Abstand voneinander aufweisen als zwei (z.B. balkenförmige) Komponenten (z.B. Balken) der Anode (z.B. entlang einer quer zu der Emissionsachse (z.B. Emissionsrichtung) verlaufenden Richtung (x, y)).

Beispiel 11 (z.B. ein Beschichtungssystem) ist eingerichtet gemäß einem der Beispiele 1 bis 10, wobei das Stellsystem (z.B. dessen kapazitives Stellglied und/oder jede Elektrode davon) ein oder mehr als ein Paar (z.B. balkenförmiger) Komponenten (z.B. Balken) aufweist, zwischen denen die Emissionsachse (z.B. Emissionsrichtung) hindurch verläuft, welche einen Abstand entlang einer quer zu der Emissionsachse (z.B. Emissionsrichtung) verlaufenden Richtung (x, y) voneinander aufweisen, der größer ist als eine Ausdehnung des Substrathalters entlang der Richtung.

Beispiel 12 (z.B. ein Beschichtungssystem) ist eingerichtet gemäß einem der Beispiele 1 bis 11, wobei das Stellsystem (z.B. dessen kapazitives Stellglied und/oder jede Elektrode davon) eine Beschichtung aufweist (z.B. jede Elektrode davon), welche beispielsweise Titan oder einen Nitrid aufweist oder daraus besteht.

Beispiel 13 (z.B. ein Beschichtungssystem) ist eingerichtet gemäß einem der Beispiele 1 bis 12, wobei das kapazitive Stellglied näher an dem Substrathalter angeordnet ist als das induktive Stellglied; und/oder wobei das induktive Stellglied näher an dem Target (oder zumindest dem Targethalter) angeordnet ist als das kapazitive Stellglied.

Beispiel 14 (z.B. ein Beschichtungssystem) ist eingerichtet gemäß einem der Beispiele 1 bis 13, ferner einen Ausbreitungsraum aufweisend, welcher sich entlang der Emissionsachse von dem Target (oder zumindest dem Targethalter) durch die Anode (z.B. zwischen zwei Balken dieser hindurch) und/oder das Stellsystem hindurch zu dem Substrathalter erstreckt, wobei der Ausbreitungsraum beispielsweise frei ist von einem Feststoff.

Beispiel 15 (z.B. ein Beschichtungssystem) ist eingerichtet gemäß einem der Beispiele 1 bis 14, wobei die Anode näher an dem Target (oder zumindest dem Targethalter) angeordnet ist als das Stellsystem.

Beispiel 16 (z.B. ein Beschichtungssystem) ist eingerichtet gemäß einem der Beispiele 1 bis 15, wobei das Stellsystem eingerichtet ist, ein magnetisches Feld und ein elektrisches Feld zu erzeugen, welche einander überlagern.

Beispiel 17 (z.B. ein Beschichtungssystem) ist eingerichtet gemäß einem der Beispiele 1 bis 16, das Stellsystem ferner eine magnetisierbare (z.B. ferromagnetische und/oder weichmagnetische) Vorrichtung (auch als Shimvorrichtung bezeichnet), z.B. ein oder mehr als ein magnetisierbare (z.B. ferromagnetische und/oder weichmagnetische) Segment aufweisend, aufweisend, welche entlang der Emissionsachse (z.B. Emissionsrichtung) erstreckt ist und/oder zwischen der Anode und dem Substrathalter angeordnet ist, vorzugsweise in einem Abstand von der Emissionsachse. Die Shimvorrichtung verbessert die Ausbreitung des magnetischen Feldes.

Beispiel 18 (z.B. ein Beschichtungssystem) ist eingerichtet gemäß Beispiel 17, wobei die Shimvorrichtung (z.B. die ein oder mehr als ein magnetisierbare Segment) zwei magnetisierbare Segmente aufweist, zwischen denen die Emissionsachse angeordnet ist; und/oder in das induktive Stellglied (z.B. dessen Windung) hinein erstreckt ist.

Beispiel 19 (z.B. ein Beschichtungssystem) ist eingerichtet gemäß Beispiel 1 bis 18, wobei die Shimvorrichtung mehrere Segmente aufweist, zwischen denen die Emissionsachse angeordnet ist und/oder welche wandförmig (dann auch als Wand bezeichnet) und/oder plattenförmig sind.

Beispiel 20 (z.B. ein Beschichtungssystem) ist eingerichtet gemäß Beispiel 1 bis 19, ferner einen Laser (auch als Laserquelle bezeichnet) aufweisend, der eingerichtet ist, einen Laserstrahl auf das Target (oder zumindest den Targethalter) zu richten zum Anregen der Bogenentladung, z.B. einen gepulsten Laserstrahl (auch als Laserpuls bezeichnet).

Beispiel 21 (z.B. ein Beschichtungssystem) ist eingerichtet gemäß einem der Beispiele 1 bis 20, das Stellsystem aufweisend: einen ersten elektrischen Anschluss zum Aufnehmen von elektrischer und/oder gepulster Leistung, mittels welcher das elektrische Feld erzeugt wird; und/oder einen oder mehr als einen zweiten elektrischen Anschluss zum Aufnehmen von elektrischer und/oder gepulster Leistung, mittels welcher das magnetische Feld erzeugt wird.

Beispiel 22 (z.B. ein Beschichtungssystem) ist eingerichtet gemäß einem der Beispiele 1 bis 21, ferner einen oder mehr als einen elektrischen Generator (z.B. Pulsgenerator und/oder zum elektrischen Versorgen des Stellsystems) aufweisend, wovon jeder Generator vorzugsweise eine Impulsstromquelle bereitstellt und/oder aufweist: eine elektrische Leistungsquelle zum Bereitstellen elektrischer Leistung, einen oder mehr als einen Schaltkreis (z.B. mehrere Schaltkreise), wovon jeder Schaltkreis aufweist: einen Ausgangsknoten (z.B. Out_1 oder Out_2) zum Abgeben der elektrischen Leistung an eine an den Generator angeschlossene Komponente des Beschichtungssystems; einen Schalter (z.B. T1 oder T4), welcher die elektrische Leistungsquelle ausgangsseitig mit dem Ausgangsknoten koppelt; vorzugsweise eine Freilaufdiode, welche in Reihe zu dem Schalter ist und die elektrische Leistungsquelle eingangsseitig mit dem Ausgangsknoten koppelt. Die Freilaufdiode reduziert anschaulich den auslaufenden Ast des Leistungspulses. Die Komponente des Beschichtungssystems kann beispielsweise eine Komponente des Stellsystems (z.B. Stellglied, Spule und/oder Stellelektrode) sein und/oder eine Elektrode (z.B. die Anode oder die Stellelektrode) des Beschichtungssystems sein.

Beispiel 23 (z.B. ein Beschichtungssystem) ist eingerichtet gemäß Beispiel 1 bis 22, ferner eine Steuervorrichtung aufweisend, welche eingerichtet ist zum Beeinflussen eines mittels der Bogenentladung durchgeführten Beschichtungsprozesses mittels Veränderns einer elektrischen Spannung, mittels welcher der Bogenentladung und/oder dem Stellsystem elektrische Leistung zugeführt wird, basierend auf einem Zustand (z.B. Soll-Zustand und/oder Ist-Zustand) des Beschichtungsprozesses.

Beispiel 24 (z.B. ein elektrischer Generator, z.B. Pulsgenerator und/oder zum Versorgen des Beschichtungssystems) ist eingerichtet gemäß einem der Beispiele 1 bis 23 und/oder weist auf: eine elektrische Leistungsquelle zum Bereitstellen elektrischer Leistung, einen oder mehr als einen Schaltkreis, wovon jeder Schaltkreis aufweist: einen Ausgangsknoten (z.B. Out_1 oder Out_2) zum Abgeben der elektrischen Leistung zu einer an den Generator angeschlossenen Elektrode (z.B. Anode oder Kathode); einen Schalter (z.B. T1 oder T4), welcher die elektrische Leistungsquelle ausgangsseitig mit dem Ausgangsknoten koppelt; vorzugsweise eine Freilaufdiode, welche in Reihe zu dem Schalter ist und die elektrische Leistungsquelle eingangsseitig mit dem Ausgangsknoten koppelt; wobei der Generator beispielsweise eine Impulsstromquelle bereitstellt.

Beispiel 25 (z.B. ein Generator) ist eingerichtet gemäß Beispiel 23 oder 24, wovon jeder Schaltkreis mittels einer Brückenschaltung (z.B. H-Brückenschaltung) bereitgestellt ist oder diese aufweist, welche die Freilaufdiode und den Schalter aufweist; und/oder wovon jeder Schaltkreis zwei Schalter aufweist, welche mittels des Ausgangsknotens miteinander in Reihe gekoppelt sind.

Beispiel 26 (z.B. ein Generator) ist eingerichtet gemäß einem der Beispiele 23 bis 25, wobei der eine oder mehr als eine Schaltkreis zwei Schaltkreise aufweist, welche beispielsweise gleichartig zueinander eingerichtet sind.

Beispiel 27 (z.B. ein Generator) ist eingerichtet gemäß einem der Beispiele 23 bis 26, wobei die Leistungsquelle einen kapazitiven Energiespeicher (z.B. einen oder mehr als einen Kondensator aufweisend) aufweist und/oder als Pulsleistungsquelle eingerichtet ist (oder zumindest als solche betrieben wird).

Beispiel 28 (z.B. ein Generator) ist eingerichtet gemäß einem der Beispiele 23 bis 27, der Schaltkreis ferner eine elektromagnetische Spule aufweisend, welche mittels des Ausgangsknotens mit dem Schalter und/oder der Freilaufdiode gekoppelt ist und/oder welche einen elektrischen Anschluss des Generators mit dem Ausgangsknoten koppelt.

Beispiel 29 (z.B. ein Generator) ist eingerichtet gemäß einem der Beispiele 23 bis 28, wobei der Schalter zwischen die elektrische Leistungsquelle und den Ausgangsknoten (z.B. in Reihe dazu) geschaltet ist.

Beispiel 30 (z.B. ein Generator) ist eingerichtet gemäß einem der Beispiele 23 bis 29, wobei die Freilaufdiode zwischen die elektrische Leistungsquelle und den Ausgangsknoten (z.B. in Reihe dazu) geschaltet ist.

Beispiel 31 (z.B. ein Generator) ist eingerichtet gemäß einem der Beispiele 23 bis 30, wobei der Ausgangsknoten zwischen die Freilaufdiode und den Schalter (z.B. in Reihe dazu) geschaltet ist.

Beispiel 32 (z.B. ein Generator) ist eingerichtet gemäß einem der Beispiele 23 bis 31, wobei der Ausgangsknoten entlang eines von der Leistungsquelle ausgehenden Strompfads hinter den Schalter geschaltet ist und die Freilaufdiode entlang des Strompfads hinter den Ausgangsknoten geschaltet ist, wobei der Strompfad beispielsweise in der Leistungsquelle mündet.

Beispiel 33 (z.B. ein Generator) ist eingerichtet gemäß einem der Beispiele 23 bis 32, ferner einen elektrischen Anschluss aufweisend, welcher mittels des Ausgangsknotens mit der Freilaufdiode und dem Schalter gekoppelt ist.

Beispiel 34 (z.B. ein Generator) ist eingerichtet gemäß einem der Beispiele 23 bis 33, ferner aufweisend: eine erste elektrische Leitung, welche den Ausgangsknoten aufweist und die Freilaufdiode mit dem Schalter koppelt; und eine zweite Leitung, welche an dem Ausgangsknoten von der ersten elektrischen Leitung abzweigt.

Beispiel 35 (z.B. eine elektrische Versorgungsvorrichtung) ist eingerichtet gemäß einem der Beispiele 23 bis 34, wobei der eine oder mehr als eine Generator zwei Generatoren aufweist (wovon jeder Generator beispielsweise gemäß einem der Beispiele 22 bis 34 eingerichtet ist); das Beispiel optional ferner aufweisend: einen dritten Anschluss zum Anschließen einer Kathode (z.B. des Targets oder des Targethalters), mittels welchem die zwei Generatoren (z.B. ausgangsseitig) miteinander gekoppelt sind (z.B. zwei Anschlüsse davon).

Beispiel 36 (z.B. eine Versorgungsvorrichtung) ist eingerichtet gemäß einem der Beispiele 22 bis 35 und/oder weist auf: einen ersten Schaltkreis, welcher eine erste elektrische Leistungsquelle, einen ersten Anschluss zum Anschließen einer ersten Anode und einen zwischen diese geschaltete erste H-Brückenschaltung aufweist; und/oder einen ersten Schaltkreis, welcher eine zweite elektrische Leistungsquelle, einen zweiten Anschluss zum Anschließen einer zweiten Anode (z.B. der Stellanode) und einen zwischen diese geschaltete zweite H-Brückenschaltung aufweist; ferner vorzugsweise einen dritten Anschluss aufweisend zum Anschließen einer Kathode (z.B. des Targets oder des Targethalters), mittels welchem die erste H-Brückenschaltung (z.B. ausgangsseitig) und die zweite H-Brückenschaltung (z.B. ausgangsseitig) elektrisch miteinander gekoppelt sind.

Beispiel 37 ist ein Verfahren, aufweisend: Zuführen von elektrischer Leistung, welcher mittels Gegenstandes gemäß einem der Beispiele 22 bis 36, erzeugt wird, zu einem Beschichtungsprozess; Verändern einer elektrischen Spannung der Leistungsquelle, mittels welcher die elektrische Leistung bereitgestellt wird, basierend auf einem Zustand (z.B. Soll-Zustand und/oder Ist-Zustand) des Beschichtungsprozesses.

Beispiel 38 (z.B. ein Verfahren) ist eingerichtet gemäß Beispiel 37, ferner ein erstes Ansteuern der Leistungsquelle aufweisend zum Verändern der elektrischen Spannung der Leistungsquelle; und/oder ein zweiten Ansteuern des Schalters aufweisend zum Erzeugen eines elektrischen Pulses, mittels welchem die elektrische Leistung dem Beschichtungsprozess zugeführt wird.

Beispiel 39 (z.B. ein Computerprogramm, das eingerichtet ist, das Verfahren) ist eingerichtet gemäß Beispiel 38 durchzuführen.

Beispiel 40 (z.B. ein computerlesbares Medium, das Instruktionen speichert, die eingerichtet sind, wenn von einem Prozessor ausgeführt, den Prozessor dazu zu bringen, das Verfahren) ist eingerichtet gemäß Beispiel 38 durchzuführen.

Beispiel 41 (z.B. eine Steuervorrichtung, welche einen oder mehr als einen Prozessor aufweist, die eingerichtet sind, das Verfahren) ist eingerichtet gemäß Beispiel 38 durchzuführen.

Beispiel 42 (z.B. eine Vakuumanordnung) ist eingerichtet gemäß einen der Beispiele 1 bis 41 und/oder die Steuervorrichtung gemäß Beispiel 41 aufweisend, ferner eine Vakuumkammer aufweisend, in welcher das Target (oder zumindest dem Targethalter) und/oder der Substrathalter angeordnet sind.

Beispiel 43 ist das Verwenden eines der Beispiele 1 bis 42 (z.B. des einen oder mehr als einen elektrischen Generators und/oder der Leistungsversorgung) zum elektrischen Versorgen einer Lichtbogenentladung, mittels welcher ein Beschichtungsprozess im Vakuum durchgeführt wird und/oder welches mehrere Schaltkreise aufweist; und/oder zum Beeinflussen einer räumlichen Ausbreitung eines Plasmas, das mittels der Lichtbogenentladung gebildet wird.

Beispiel 44 ist eingerichtet gemäß einem der Beispiele 1 bis 43, wobei die Lichtbogenentladung zwischen einer Anode und einer Kathode, z.B. das Target (oder zumindest dem Targethalter) aufweisend, vermittelt wird, wovon die Anode mittels eines ersten Schaltkreises (z.B. der mehreren Schaltkreise) elektrisch versorgt wird (z.B. mit einem Leistungspuls) und/oder wovon die Kathode mittels eines zweiten Schaltkreises (z.B. der mehreren Schaltkreise) elektrische versorgt wird (z.B. mit einem Leistungspuls).

Beispiel 45 ist eingerichtet gemäß einem der Beispiele 1 bis 44, wobei das Stellsystem entlang der Emissionsachse einen Abstand von dem Targethalter (z.B. dessen Drehachse) und/oder dem Target aufweist; wobei vorzugsweise das kapazitive Stellglied (z.B. die Elektrode) entlang der Emissionsachse einen Abstand von dem Targethalter (z.B. dessen Drehachse) und/oder dem Target aufweist; und/oder wobei vorzugsweise das induktive Stellglied (z.B. der Elektromagnet) entlang der Emissionsachse einen Abstand von dem Targethalter (z.B. dessen Drehachse) und/oder dem Target aufweist.

Beispiel 46 ist eingerichtet gemäß einem der Beispiele 1 bis 45, wobei das induktives Stellglied mittels eines Elektromagneten bereitgestellt ist, welcher beispielsweise eine oder mehr als eine elektromagnetische Spule aufweist.

Beispiel 47 ist eingerichtet gemäß einem der Beispiele 1 bis 46, wobei die Durchgangsöffnung, von welcher das Stellsystem entlang der Emissionsachse durchdrungen ist, eine erste Ausdehnung aufweist entlang einer ersten Richtung (z.B. Gravitationsrichtung) aufweist, die größer ist als eine dazu parallele Ausdehnung des Substrathalters (z.B. des Substrats) des Targethalters (z.B. Targets); und/oder wobei die Durchgangsöffnung, von welcher das Stellsystem entlang der Emissionsachse durchdrungen ist, eine zweite Ausdehnung aufweist entlang einer zweite Richtung aufweist, die größer ist als eine dazu parallele Ausdehnung des Substrathalters (z.B. des Substrats) des Targethalters (z.B. Targets); wobei beispielsweise die erste Richtung und die zweite Richtung quer zur Emissionsachse sind und/oder quer zueinander sind.

Beispiel 48 ist eingerichtet gemäß einem der Beispiele 1 bis 47, wobei die Durchgangsöffnung, von welcher das Stellsystem (z.B. dessen kapazitives Stellglied und/oder dessen Elektrode/Elektroden) entlang der Emissionsachse durchdrungen ist, eine erste Ausdehnung aufweist entlang einer ersten Richtung (z.B. Gravitationsrichtung) aufweist, die größer ist als eine dazu parallele Ausdehnung des Substrathalters (z.B. des Substrats) und/oder des Targethalters (z.B. Targets); und/oder wobei die Durchgangsöffnung, von welcher das kapazitive Stellglied (z.B. dessen Elektrode) entlang der Emissionsachse durchdrungen ist, eine zweite Ausdehnung aufweist entlang einer zweite Richtung aufweist, die größer ist als eine dazu parallele Ausdehnung des Substrathalters (z.B. des Substrats) des Targethalters (z.B. Targets); wobei beispielsweise die erste Richtung und die zweite Richtung quer zur Emissionsachse sind und/oder quer zueinander sind.

Beispiel 49 ist das Verwenden eines der Beispiele 1 bis 48, wobei die Durchgangsöffnung, von welcher das Stellsystem (z.B. dessen induktives Stellglied und/oder dessen Spule/Spulen) entlang der Emissionsachse durchdrungen ist, eine erste Ausdehnung aufweist entlang einer ersten Richtung (z.B. Gravitationsrichtung) aufweist, die größer ist als eine dazu parallele Ausdehnung des Substrathalters (z.B. des Substrats) des Targethalters (z.B. Targets); und/oder wobei die Durchgangsöffnung, von welcher das induktive Stellglied (z.B. dessen Spule/Spulen) entlang der Emissionsachse durchdrungen ist, eine zweite Ausdehnung aufweist entlang einer zweite Richtung aufweist, die größer ist als eine dazu parallele Ausdehnung des Substrathalters (z.B. des Substrats) des Targethalters (z.B. Targets); wobei beispielsweise die erste Richtung und die zweite Richtung quer zur Emissionsachse sind und/oder quer zueinander sind.

Beispiel 50 ist das Verwenden eines elektrischen Generators zum Versorgen eines Beschichtungsprozesses mittels einer Lichtbogenentladung, wobei der Generator aufweist: eine elektrische Leistungsquelle zum Bereitstellen elektrischer Leistung, einen oder mehr als einen Schaltkreis, wovon jeder Schaltkreis aufweist: einen Ausgangsknoten zum Abgeben der elektrischen Leistung zu einer an den Generator angeschlossenen Elektrode; einen Schalter, welcher die elektrische Leistungsquelle ausgangsseitig mit dem Ausgangsknoten koppelt; vorzugsweise eine Freilaufdiode, welche in Reihe zu dem Schalter ist und die elektrische Leistungsquelle eingangsseitig mit dem Ausgangsknoten koppelt.

Beispiel 51 (z.B. das Verwenden) ist eingerichtet gemäß einem der Beispiele 1 bis 50, wobei der eine oder mehr als eine Generator zwei Generatoren aufweist, das Beschichtungssystem ferner einen dritten Anschluss zum Anschließen des Targethalters aufweisend, mittels welchem die zwei Generatoren miteinander gekoppelt sind.

Beispiel 52 (z.B. das Verwenden) ist eingerichtet gemäß einem der Beispiele 1 bis 51, wobei die Kathode das Target oder zumindest den Targethalter aufweist oder daraus besteht.

Beispiel 53 (z.B. das Verwenden) ist eingerichtet gemäß einem der Beispiele 1 bis 52, wobei der Targethalter zum Halten eines Targets eingerichtet ist und/oder eingerichtet ist, dem Target eine Drehachse bereitzustellen.

Beispiel 54 ist eingerichtet gemäß einem der Beispiele 1 bis 53, wobei dem kapazitiven Stellgliedgepulster elektrische Leistung (auch als Leistungspulse bezeichnet) zugeführt wird.

Beispiel 55 ist das Verwenden eines der Beispiele 1 bis 54, wobei dem kapazitiven Stellgliedgepulster elektrische Leistung (auch als Leistungspulse bezeichnet) zugeführt wird.

Beispiel 56 ist das Verwenden eines der Beispiele 1 bis 55, wobei das Stellsystem (oder zumindest das induktive Stellglied) zwischen der Anode und dem Targethalter angeordnet ist.

Beispiel 57 ist das Verwenden eines der Beispiele 1 bis 56, wobei das kapazitive Stellglied zwischen der Anode und dem Targethalter angeordnet ist; oder wobei das kapazitive Stellglied entlang der Emissionsachse hinter dem Targethalter angeordnet ist.

Es zeigen

Figur 1A ein Beschichtungssystem gemäß verschiedenen Ausführungsformen in einer schematischen Seitenansicht oder Querschnittsansicht;

Figur 1B verschiedene Aspekte zur Lichtbogenentladung gemäß verschiedenen Ausführungsformen in einem schematischen Prozessdiagramm;

Figur 2A ein Beschichtungssystem gemäß verschiedenen Ausführungsformen in einer schematischen Seitenansicht oder Querschnittsansicht;

Figur 2B ein Beschichtungssystem gemäß verschiedenen Ausführungsformen in einem schematischen Verschaltungsplan;

Figur 3A einen Generator gemäß verschiedenen Ausführungsformen in einem schematischen Verschaltungsplan;

Figur 3B einen Generator gemäß verschiedenen Ausführungsformen in einem schematischen Verschaltungsplan; und

Figur 4 ein Beschichtungssystem gemäß verschiedenen Ausführungsformen in einer schematischen Perspektivansicht.

In der folgenden ausführlichen Beschreibung wird auf die beigefügten Zeichnungen Bezug genommen, die Teil dieser bilden und in denen zur Veranschaulichung spezifische Ausführungsformen gezeigt sind, in denen die Erfindung ausgeübt werden kann. In dieser Hinsicht wird Richtungsterminologie wie etwa "oben", "unten", "vorne", "hinten", "vorderes", "hinteres", usw. mit Bezug auf die Orientierung der beschriebenen Figur(en) verwendet. Da Komponenten von Ausführungsformen in einer Anzahl verschiedener Orientierungen positioniert werden können, dient die Richtungsterminologie zur Veranschaulichung und ist auf keinerlei Weise einschränkend. Es versteht sich, dass andere Ausführungsformen benutzt und strukturelle oder logische Änderungen vorgenommen werden können, ohne von dem Schutzumfang der vorliegenden Erfindung abzuweichen. Es versteht sich, dass die Merkmale der hierin beschriebenen verschiedenen beispielhaften Ausführungsformen miteinander kombiniert werden können, sofern nicht spezifisch anders angegeben. Die folgende ausführliche Beschreibung ist deshalb nicht in einschränkendem Sinne aufzufassen, und der Schutzumfang der vorliegenden Erfindung wird durch die angefügten Ansprüche definiert.

Im Rahmen dieser Beschreibung werden die Begriffe "verbunden", "angeschlossen" sowie "gekoppelt" verwendet zum Beschreiben sowohl einer direkten als auch einer indirekten Verbindung (z.B. ohmsch und/oder elektrisch leitfähig, z.B. einer elektrisch leitfähigen Verbindung), eines direkten oder indirekten Anschlusses sowie einer direkten oder indirekten Kopplung. In den Figuren werden identische oder ähnliche Elemente mit identischen Bezugszeichen versehen, soweit dies zweckmäßig ist. Gemäß verschiedenen Ausführungsformen kann der Begriff "gekoppelt" oder "Kopplung" im Sinne einer (z.B. mechanischen, hydrostatischen, thermischen und/oder elektrischen), z.B. direkten oder indirekten, Verbindung und/oder Wechselwirkung verstanden werden.

Mehrere Elemente können beispielsweise entlang einer Wechselwirkungskette miteinander gekoppelt sein, entlang welcher die Wechselwirkung ausgetauscht werden kann, z.B. ein Fluid (dann auch als fluidleitend gekoppelt bezeichnet). Beispielsweise können zwei miteinander gekoppelte Elemente eine Wechselwirkung miteinander austauschen, z.B. eine mechanische, hydrostatische, thermische und/oder elektrische Wechselwirkung. Eine Kopplung mehrerer Vakuumkomponenten (z.B. Ventilen, Pumpen, Kammern, usw.) miteinander kann aufweisen, dass diese fluidleitend miteinander gekoppelt sind. Gemäß verschiedenen Ausführungsformen kann "gekuppelt" im Sinne einer mechanischen (z.B. körperlichen bzw. physikalischen) Kopplung verstanden werden, z.B. mittels eines direkten körperlichen Kontakts. Eine Kupplung kann eingerichtet sein, eine mechanische Wechselwirkung (z.B. Kraft, Drehmoment, etc.) zu übertragen.

Als Ist-Zustand einer Entität (z.B. einer Vorrichtung, eines Systems oder eines Vorgangs bzw. Prozesses) kann der tatsächlich vorliegende bzw. sensorisch erfassbare Zustand der Entität verstanden werden. Als Soll-Zustand der Entität kann der angestrebte Zustand, d.h. eine Vorgabe, verstanden werden. Als Steuern kann eine beabsichtigte Beeinflussung des momentanen Zustands (auch als Ist-Zustand bezeichnet) der Entität verstanden werden. Dabei kann der momentane Zustand gemäß der Vorgabe (auch als Soll-Zustand bezeichnet) verändert werden, z.B. indem ein oder mehr als ein Betriebsparameter (dann auch als Stellgröße bezeichnet) der Entität verändert wird, z.B. mittels eines Stellglieds. Regeln kann als Steuern verstanden werden, wobei zusätzlich einer Zustandsänderung durch Störungen entgegengewirkt wird. Dazu wird der Ist-Zustand mit dem Soll-Zustand verglichen und die Entität derart beeinflusst, z.B. mittels eines Stellglieds, dass die Abweichung des Ist-Zustands von dem Soll-Zustand minimiert wird. Die Regelung implementiert somit im Gegensatz zu der reinen vorwärts gerichteten Ablaufsteuerung eine fortlaufende Einflussnahme der Ausgangsgröße auf die Eingangsgröße, welche durch den sogenannten Regelkreis bewirkt wird (auch als Rückführung bezeichnet). Mit anderen Worten kann hierin verstanden werden, dass alternativ oder zusätzlich zu der Steuerung (bzw. dem Ansteuern) eine Regelung verwendet werden kann bzw. alternativ oder zusätzlich zu dem Steuern ein Regeln erfolgen kann. Der Zustand einer steuerbaren Vorrichtung (z.B. einer Strukturierungsvorrichtung) bzw. eines steuerbaren Vorgangs (z.B. das Strukturieren) lässt sich als Punkt (auch als Arbeitspunkt oder Betriebspunkt bezeichnet) in einem Raum (auch als Zustandsraum bezeichnet) angeben, der von den veränderlichen Parametern der Vorrichtung bzw. des Vorgangs (auch als Betriebsparameter bezeichnet) aufgespannt wird. Der Zustand der Vorrichtung bzw. des Vorgangs ist somit eine Funktion des jeweiligen Werts eines oder mehr als eines Betriebsparameters, welcher den Zustand der Vorrichtung bzw. des Vorgangs somit repräsentiert. Der Ist-Zustand kann basierend auf einer Messung (z.B. mittels eines Messglieds) eines oder mehr als eines Betriebsparameters (dann auch als Regelgröße bezeichnet) ermittelt werden.

Der Begriff "Steuervorrichtung" kann als jede Art einer Logik implementierenden Entität verstanden werden, die beispielsweise eine Verschaltung und/oder einen Prozessor aufweisen kann, welche Software ausführen kann, die in einem Speichermedium, in einer Firmware oder in einer Kombination davon gespeichert ist, und darauf basierend Anweisungen ausgeben kann. Die Steuervorrichtung kann beispielsweise mittels Codesegmenten (z.B. Software) konfiguriert sein, um den Betrieb eines Systems (z.B. seines Arbeitspunkts), z.B. einer Maschine oder einer Anlage, z.B. zumindest seiner kinematischen Kette, zu steuern.

Der Begriff "Prozessor", wie hierin verwendet, kann als jede Art von Entität verstanden werden, die die Verarbeitung von Daten oder Signalen erlaubt. Die Daten oder Signale können beispielsweise gemäß zumindest einer (d.h. einer oder mehr als einer) spezifischen Funktion behandelt werden, die vom Prozessor ausgeführt wird. Ein Prozessor kann eine analoge Schaltung, eine digitale Schaltung, eine Mischsignalschaltung, eine Logikschaltung, einen Mikroprozessor, eine zentrale Verarbeitungseinheit (CPU), eine Grafikverarbeitungseinheit (GPU), einen digitalen Signalprozessor (DSP), eine programmierbare Gatter-Anordnung (FPGA), eine integrierte Schaltung oder eine beliebige Kombination davon aufweisen oder daraus gebildet sein. Jede andere Art der Implementierung der jeweiligen Funktionen, die nachstehend ausführlicher beschrieben werden, kann auch als Prozessor oder Logikschaltung verstanden werden. Es versteht sich, dass einer oder mehrere der hierin detailliert beschriebenen Verfahrensschritte von einem Prozessor ausgeführt (z.B. realisiert) werden können, durch eine oder mehrere spezifische Funktionen, die von dem Prozessor ausgeführt werden. Der Prozessor kann daher eingerichtet sein, eines der hierin beschriebenen Verfahren oder dessen Komponenten zur Informationsverarbeitung durchzuführen.

Der Begriff "System" kann als ein Satz interagierender Entitäten (z.B. Glieder) verstanden werden. Der Satz interagierender Entitäten kann beispielsweise zumindest eine mechanische Komponente, zumindest einen elektromechanischen Wandler (oder andere Arten von Stellgliedern), zumindest eine elektrische Komponente, zumindest eine Anweisung (z.B. in einem Speichermedium codiert), und/oder zumindest eine Steuervorrichtung aufweisen oder daraus gebildet sein.

Der Begriff "Stellglied" (z.B. einen Aktuator bzw. Aktor aufweisend) kann als ein Wandler verstanden werden, der zum Beeinflussen eines Zustandes, eines Vorgangs (z.B. eines Beschichtungsprozesses) oder einer Vorrichtung in Antwort auf ein Ansteuern des Stellglieds eingerichtet ist. Das Stellglied kann ein diesem zugeführtes Ansteuersignal (mittels dessen das Ansteuern erfolgt) in mechanische Bewegungen bzw. Veränderungen physikalischer Größen wie Druck oder Temperatur umsetzen. Ein Stellglied kann eingerichtet sein, Einfluss auf den Ist-Zustand (auch als Arbeitspunkt bezeichnet) des Prozesses zu nehmen (z.B. auf dessen Stellgröße), der mittels des Stellglieds versorgt wird. Der Einfluss kann direkt oder indirekt sein. Stellgröße und Regelgröße können sich beispielsweise voneinander unterscheiden. Die Regelgröße (z.B. Druck) kann dann entsprechend eine Funktion einer oder mehr als einer Stellgröße (z.B. Spannung) sein.

Gemäß verschiedenen Ausführungsformen kann eine Lagervorrichtung zum Lagern (z.B. geführten Positionieren und/oder Halten) eines oder mehr als eines Bauteils eingerichtet sein. Beispielsweise kann die Lagervorrichtung, zum Beispiel pro Bauteil, ein oder mehr als ein Lager aufweisen zum Lagern (z.B. geführten Positionieren und/oder Halten) des Bauteils. Jedes Lager der Ladevorrichtung kann eingerichtet sein, dem Bauteil einen oder mehr als einen Freiheitsgrad (beispielsweise Translationsfreiheitsgrad oder Rotationsfreiheitsgrad) bereitzustellen, gemäß welchem das Bauteil bewegt werden kann. Beispiele für ein Lager weisen auf: Radiallager, Axiallager, Radiaxlager, Linearlager (auch als Linearführung bezeichnet). Pro Linearlager kann dem Bauteil beispielsweise genau einen Translationsfreiheitsgrad bereitgestellt sein.

Gemäß verschiedenen Ausführungsformen kann die Vakuumkammer mittels eines Kammergehäuses bereitgestellt sein oder werden, in dem eine Kammer oder mehrere Kammern bereitgestellt sein oder werden können. Das Kammergehäuse kann beispielsweise zum Bereitstellen eines Unterdrucks oder eines Vakuums (Vakuumkammergehäuse) mit einer Pumpenanordnung, z.B. einer Vakuumpumpenanordnung, (z.B. gasleitend) gekoppelt sein und derart stabil eingerichtet sein, dass diese dem Einwirken des Luftdrucks im abgepumpten Zustand standhält. Die Pumpenanordnung (aufweisend zumindest eine Vakuumpumpe, z.B. eine Hochvakuumpumpe, z.B. eine Turbomolekularpumpe) kann es ermöglichen, einen Teil des Gases aus dem Inneren der Prozessierkammer, z.B. aus dem Prozessierraum, abzupumpen. Dementsprechend kann eine Vakuumkammer oder können mehrere Vakuumkammern in einem Kammergehäuse bereitgestellt sein. Mit anderen Worten kann das Kammergehäuse als Vakuumkammergehäuse eingerichtet sein bzw. kann eine Beschichtungskammer als eine Vakuumkammer eingerichtet sein.

Der Begriff "Vakuumdruck" bezeichnet hierin einen Unterdruck im Bereich des Vakuums (d.h. ein Druck von weniger als 0,3 bar), z.B. ein Druck in einem Bereich von ungefähr 10 mbar bis ungefähr 1 mbar (mit anderen Worten Grobvakuum) bereitgestellt werden kann oder weniger, z.B. ein Druck in einem Bereich von ungefähr 1 mbar bis ungefähr $10^{-3}$ mbar (mit anderen Worten Feinvakuum) oder weniger, z.B. ein Druck in einem Bereich von ungefähr $10^{-3}$ mbar bis ungefähr $10^{-7}$ mbar (mit anderen Worten Hochvakuum) oder weniger, z.B. ein Druck von kleiner als Hochvakuum, z.B. kleiner als ungefähr $10^{-7}$ mbar.

Eine Antriebsvorrichtung kann hierin als Wandler verstanden werden, welche eingerichtet ist, elektrische Energie in mechanische Energie umzuwandeln. Eine Antriebsvorrichtung kann beispielsweise einen elektrischen Motor (z.B. mit elektrischen Spulen) aufweisen. Eine Antriebsvorrichtung kann beispielsweise einen Kompressor und einen damit gekoppelten Hubkolben aufweisen. Eine Antriebsvorrichtung kann beispielsweise ein oder mehr als ein Piezoelement aufweisen. Beispielsweise kann die Antriebsvorrichtung eingerichtet sein, die mechanische Energie mittels eines Drehmoments bzw. einer Drehbewegung auszugeben.

Als Lichtbogenverdampfung wird ein Überführen eines festen Verdampfungsguts in einen gasförmigen Aggregatszustand mittel der Lichtbogenentladung verstanden. Das Targetmaterial, wenn in den gasförmigen Aggregatszustand überführt, kann als Beschichtungsmaterial, z.B. als das Schichtbildungsmaterial, verwendet werden.

Das Lichtbogenverdampfen, d.h. das Verdampfen mittels einer Lichtbogenentladung, gehört zur Klasse der thermischen Verdampfungsprozesse, denen gemein ist, dass ein zu verdampfendes Material (hierin vereinfacht auch als Beschichtungsmaterial bezeichnet) derart erhitzt wird, dass es in seinen gasförmigen Zustand (auch als Materialdampf bezeichnet) übergeht (z.B. unter Aufnahme von latenter Wärme). Dabei kann (d.h. muss aber nicht notwendigerweise) als Zwischenschritt eine Schmelze des Materials vorliegen.

Beispielsweise kann dieses aus der Schmelze verdampfen oder direkt sublimieren. Als Lichtbogenentladung wird eine Form der Gasentladung bezeichnet, bei welcher das dabei gebildete Plasma zu einem Schlauch (oder anschaulich dünnen Faden, den sogenannten Lichtbogen) zusammengezogen wird. Innerhalb des so gebildeten Plasmaschlauchs treten hohe Gastemperaturen (z.B. in einem Bereich sein von ungefähr 5000 Kelvin bis ungefähr 50000 Kelvin), Stromstärken (z.B. in einem Bereich sein von ungefähr 2000 Ampere oder mehr) sowie Gasdrücke auf, mittels welchen das Beschichtungsmaterial in die gasförmige Phase (auch als Verdampfen bezeichnet) überführt wird. Die Lichtbogenentladung und damit die Plasmabildung können von kurzer Dauer sein, so dass diese gepulst erfolgt. Das Lichtbogenverdampfen ist von dem Prozess der Kathodenzerstäubung (das sogenannte Sputtern) zu unterscheiden, bei welcher das Plasma mittels einer (z.B. kontinuierlichen oder gepulsten) Glimmentladung erzeugt wird.

Bei einer Variante des Lichtbogenverdampfen wird ein Laser verwendet, um das Zünden der Lichtbogenentladung zu steuern, welcher lokal das Bilden eines Plasmas angeregt (auch als Laser-induzierte oder Laser-unterstützte Lichtbogenentladung oder Laser-Arcen bezeichnet). Hierbei erzeugt der Laser innerhalb der Plasmakammer zwischen der Anode und der Kathode ein sehr kurzes gepulstes Plasma (zur Entladungszündung eines initialen Plasmas). Dieses initiale Plasma von einigen 10 ns (Nanosekunden) bis 100 ns Dauer wird danach durch eine Bogenentladung mittels einer elektrischen (Impuls-) Versorgungsvorrichtung (z.B. einer Impulsstromquelle) in der Impulslänge und Leistung verstärkt. Das so gebildete Plasma senkt die Impedanz zwischen Kathode und Anode, so dass eine zwischen diesen anliegende Spannung zu einem Entladungsstrom durch das Plasma hindurch führt. Mit anderen Worten kann mittels des Lasers eine gepulste Lichtbogenentladung angeregt werden. Dabei wird der Laser mittels eines Spiegelsystems über die Kathode geführt, so dass der Ort der Lichtbogenentladung gezielt verändert werden kann. Der Laser beeinflusst dabei den Ort der Entladungszündung auf der Kathode und sorgt somit für einen gleichmäßigen kontaktfreien Abtrag des Targetmaterials.

Als Anregungsquelle (z.B. Laserquelle) wird eine Vorrichtung bezeichnet, die eingerichtet ist, einen Anregungspuls zu erzeugen, beispielsweise einen Strahlungspuls, einen Leistungspuls (z.B. vermittelt als Strompuls oder einen Spannungspuls) oder Ähnliches. Die Anregungsquelle ist im Allgemeinen eingerichtet, eine Plasmaentladung (z.B. eine Plasmabildung und/oder einen elektrischen Ladungstransfer mittels des Plasmas) anzuregen (z.B. auszulösen) mittels des Anregungspulses. Beispielsweise kann ein elektrischer Spannungspuls als Anregungspuls verwendet werden, um die Plasmaentladung auszulösen. Als Laserquelle wird eine Vorrichtung bezeichnet, die eingerichtet ist, einen Laserstrahl zu erzeugen. Als Laserstrahl wird eine gerichtete (z.B. kollineare und/oder kollimierte) Ausbreitung elektromagnetischer Wellen verstanden, welche beispielsweise stimuliert erfolgt und/oder kohärent ist. Die Laserquelle kann beispielsweise einen elektromagnetischen Resonator aufweisen, mittels welcher die stimulierte Emission des Laserstrahls erfolgt. Im Gegensatz zum Dauerstrichlaser erzeugt eine gepulst betriebene Laserquelle gepulste Laserstrahlung (auch als Laserpuls bezeichnet). Der Laserpuls kann mittels gepulster Anregung oder beispielsweise auch mittels eines Güteschalters im Laser selbst erzeugt werden. Beispiele für die Laserquelle weisen auf: Gaslaser (z.B. Kohlendioxidlaser) und Festkörperlaser (z.B. Halbleiterlaser).

In einer Modifikation des Lichtbogenverdampfen (auch als ARC-Verdampfung bezeichnet) wird ein Laser verwendet, um das Zünden der Lichtbogenentladung zu steuern, welcher lokal das Bilden eines Plasmas angeregt (auch als Laser-induzierte oder Laser unterstützte Lichtbogenentladung bezeichnet). Hierbei erzeugt der Laser innerhalb der Plasmakammer zwischen der Anode und der Kathode ein sehr kurzes gepulstes Plasma (zur Entladungszündung eines initialen Plasmas). Dieses initiale Plasma von einigen 10 ns (Nanosekunden) bis 100 ns Dauer wird danach durch eine Bogenentladung mittels einer elektrischen Versorgungsvorrichtung (beispielsweise Impulsgenerator und/oder Impulsstromquelle) in der Impulslänge und Leistung verstärkt. Das so gebildete Plasma senkt die Impedanz zwischen Kathode und Anode, so dass eine zwischen Kathode und Anode anliegende Spannung $U\_arc$ (auch als Arc-Spannung bezeichnet) zu einem Entladungsstrom durch das Plasma hindurch führt. Mit anderen Worten kann mittels des Lasers eine gepulste Lichtbogenentladung angeregt werden.

Ein "Puls" bezogen auf eine physikalische Größe (beispielsweise Leistung, dann auch als Leistungspuls bezeichnet) kann als zeitliche Veränderung der Größe verstanden werden derart, dass der Wert der Größe (z.B. von einem Anfangswert, beispielsweise Null, ausgehend) zunimmt, ein Maximum (auch als Peakwert bezeichnet) überschreitet, und dann wieder abnimmt (z.B. auf den Anfangswert).

Ein Plasma kann mittels eines sogenannten Arbeitsgases (auch als plasmabildendes Gas bezeichnet) gebildet werden. Gemäß verschiedenen Ausführungsformen kann das Arbeitsgas ein gasförmiges Material aufweisen, welches reaktionsträge ist, mit anderen Worten, welches sich nur an wenigen oder gar keinen chemischen Reaktionen beteiligt. Ein Arbeitsgas kann beispielsweise von dem verwendeten Targetmaterial definiert sein oder werden und an dieses angepasst sein oder werden. Beispielsweise kann ein Arbeitsgas ein Gas oder ein Gasgemisch aufweisen, welches mit dem Targetmaterial nicht zu einem Feststoff reagiert. Das Arbeitsgas kann beispielsweise ein Edelgas (z.B. Helium, Neon, Argon, Krypton, Xenon, Radon) oder mehrere Edelgase aufweisen. Aus dem Arbeitsgas kann das Plasma gebildet werden, welches beispielsweise im Wesentlichen das Zerstäuben des Targetmaterials bewirkt. Wird ein Reaktivgas verwendet, kann dieses eine höhere chemische Reaktivität als das Arbeitsgas aufweisen, z.B. bezüglich des Targetmaterials. Mit anderen Worten kann das zerstäubte Targetmaterial zusammen mit dem Reaktivgas (wenn vorhanden) schneller reagieren (d.h. mehr Reaktionsprodukt pro Zeit bilden) als zusammen mit dem Arbeitsgas (z.B. wenn es überhaupt mit dem Arbeitsgas chemisch reagiert). Das Reaktivgas und das Arbeitsgas können gemeinsam oder getrennt als Prozessgas (z.B. als Gasgemisch) zugeführt werden, beispielsweise mittels der Gaszuführvorrichtung.

Als Elektrode wird hierin ein elektrisch leitfähiges und/oder metallisches Objekt (z.B. Körper oder Verbund mehrerer Körper) verstanden, an welchen im Betrieb ein elektrisches Potential (auch als Elektrodenpotential bezeichnet) angelegt werden kann und/oder das elektrische Potential verändert werden kann. Die Elektrode kann beispielsweise eine oder mehr als eine plattenförmige Komponente (auch als Elektrodenplatte bezeichnet) aufweisen, eine oder mehr als eine drahtförmige Komponente (auch als Elektrodendraht bezeichnet) aufweisen und/oder eine oder mehr als eine balkenförmige Komponente (auch als Elektrodenbalken bezeichnet) aufweisen. Die Elektrode kann ferner mit einem Schaltkreis elektrisch gekoppelt sein, welcher beispielsweise eingerichtet ist, das Elektrodenpotential bereitzustellen. Je nach Implementierung kann eine Elektrode als Anode oder als Kathode eingerichtet sein, und dementsprechend betrieben werden. Mittels der Elektrode kann beispielsweise ein elektrisches Versorgen des Beschichtungsprozesses erfolgen.

Der Begriff "Beschichtungsmaterial" bezeichnet hierin allgemein ein Material, mittels dessen ein Beschichtungsprozess durchgeführt werden kann, bei dem eine oder mehr als eine Schicht gebildet wird (auch als Beschichten bezeichnet). Das Beschichtungsmaterial kann z.B. die chemische Zusammensetzung der Schicht (dann auch als Schichtbildungsmaterial bezeichnet) aufweisen oder zu dem Schichtbildungsmaterial chemisch reagieren. Alternativ oder zusätzlich kann das Beschichtungsmaterial in einem Tiegel angeordnet sein oder werden (dann auch als Verdampfungsgut bezeichnet).

Hierin wird unter anderem auf eine Drehachse Bezug genommen, insbesondere für eine drehbar gelagerte Komponente (z.B. Target oder Substrat) und/oder eine zum Lagern dieser eingerichteten Lagervorrichtung (z.B. des Targethalters oder Substrathalters). Diesbezüglich kann verstanden werden, dass das für die Drehachse Beschriebene in Analogie gelten kann für eine Achse der Längserstreckung, beispielsweise wenn keine drehbare Lagerung vorhanden ist.

Zum einfacheren Verständnis wird hierin auf die Ausdehnung von Target und Substrat Bezug genommen. Gemäß verschiedenen Ausführungsformen kann der Substrathalter einen Aufnahmebereich (z.B. einen Hohlraum) aufweisen zum Aufnehmen des Substrats. Dann kann das für die Ausdehnung des Substrats Beschriebene in Analogie gelten für die Ausdehnung des Aufnahmebereich, beispielsweise wenn kein Substrat vorhanden ist. Alternativ oder zusätzlich kann der Targethalter einen Aufnahmebereich (z.B. einen Hohlraum) aufweisen zum Aufnehmen des Targets. Dann kann das für die Ausdehnung des Targets Beschriebene in Analogie gelten für die Ausdehnung des Aufnahmebereich, beispielsweise wenn kein Target vorhanden ist.

Der Begriff "weichmagnetisch" kann verstanden werden als eine Koerzitivfeldstärke von weniger als ungefähr 500 kA/m aufweisend, z.B. von weniger als ungefähr 100 kA/m, z.B. von weniger als ungefähr 10 kA/m, z.B. von weniger als ungefähr 1 kA/m. Eine weichmagnetische Komponente kann beispielsweise eine Legierung aufweisend Eisen, Nickel und/oder Cobalt, Stahl, einen Pulverwerkstoff und/oder einen Weichferrit (z.B. Nickelzinn und/oder Manganzinn aufweisend) aufweisen oder daraus gebildet sein.

Als Spulenachse wird hierin die Achse einer Spule verstanden, um welche herum die elektrische Leitung der Spule herum erstreckt ist, um die Windungen der Spule bereitzustellen. Die Spulenachse kann beispielsweise die Symmetrieachse der Spule bezeichnen. Beispielsweise können die Windungen einer Spule einer Schraubenlinie (Helix) folgen. Die Schraubenlinie kann anschaulich entlang einer Kurve auf der Mantelfläche eines Zylinders verlaufen. Die Zylinderachse fällt in diesem Fall mit der Spulenachse zusammen. Weichen die Windungen einer realen Spule von einer solchen idealen Schraubenlinie ab, kann im Allgemeinen eine Schraubenlinie gefunden werden, welche im Mittel die geringste räumliche Abweichung von den Windungen der Spule aufweist. Diese Schraubenlinie kann dann die Zylinderachse definieren, wie vorstehend beschrieben ist, welche mit der Spulenachse zusammenfällt. Optional kann die oder jede Spule mehrlagig sein, d.h. diese kann mehrere Lagen aufweisen, von denen jede Lage mehrere Windungen aufweisen kann. Die Windungen jeder Lage der Spule können eine gemeinsame Spulenachse aufweisen, z.B. wenn diese einer Schraubenlinie (Helix) mit gemeinsamer Zylinderachse folgen.

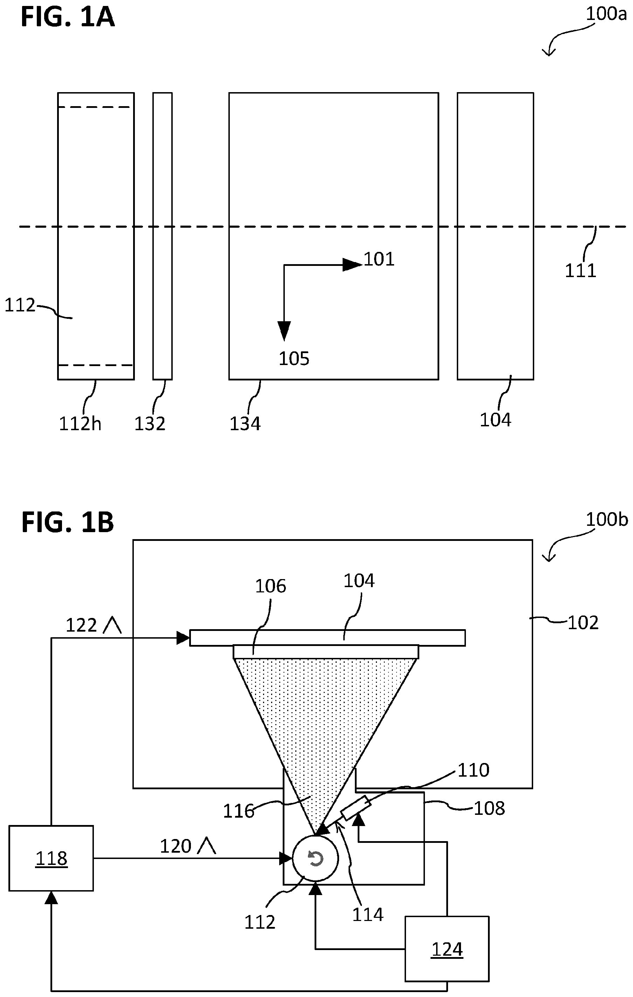

**Fig.1A** veranschaulicht ein Beschichtungssystem gemäß verschiedenen Ausführungsformen 100a in einer schematischen Seitenansicht oder Querschnittsansicht, vorzugsweise eingerichtet gemäß Beispiel 1. Der Targethalter 112h kann einen Aufnahmebereich zum Aufnehmen des Targets 112 aufweisen, welches mittels des Targethalters 112h gehalten wird, und beispielsweise außerhalb des Betriebs des Beschichtungssystems demontiert sein kann.

Die Emissionsachse 111 (auch als Ausbreitungsachse bezeichnet) ist entlang einer Emissionsrichtung 101 erstreckt, welche von dem Targethalter 112h auf den Substrathalter 104 hin gerichtet ist. Entlang der Emissionsrichtung 101 sind hintereinander angeordnet: die Anode 132, das Stellsystem 134 und der Substrathalter 104. Eine exemplarische Implementierung der Emissionsachse 111 ist quer oder parallel zur Gravitationsrichtung 105 (d.h. Richtung der Gravitationskraft) ausgerichtet.

Eine exemplarische Implementierung des Targets 112 ist drehbar gelagert mittels einer Lagervorrichtung als Targethalter (nicht dargestellt). Dies verlängert die Lebensdauer des Targets, insbesondere wenn dieses im Betrieb, z.B. während des Lichtbogenverdampfens, gedreht wird. Die Drehachse des Targets 112 kann beispielsweise quer zur Emissionsachse 111 ausgerichtet sein.

In Analogie dazu weist eine exemplarische Implementierung des Substrathalters 104 eine Lagervorrichtung auf, mittels welcher das Substrat drehbar gelagert sein kann. Die Drehachse des Substrats kann beispielsweise entlang der Drehachse des Targets 112 sein. Alternativ kann der Substrathalter 104 eingerichtet sein, das Substrat entlang einer Transportrichtung an dem Target 112 vorbei zu transportieren, z.B. mittels einer oder mehr als einer Transportrolle des Substrathalters 104. In dem Fall kann das Substrat plattenförmig oder bandförmig sein.

Die Anode 132 ist eingerichtet, im Betrieb das Bilden einer Bogenentladung anzuregen, welche zwischen dem Target und der Anode vermittelt wird. Mittels der Bogenentladung kann ein Teil des Targets 112 in die gasförmige Phase überführt werden und sich das so vom Target 112 getrennte Material (zumindest teilweise als Plasma) in Emissionsrichtung 101 zu dem Substrathalter hin ausbreiten (auch als Materialstrom 116 bezeichnet, siehe Fig.1B).

Eine exemplarische Implementierung des Stellsystems 134 weist einen oder mehr als einen elektromagnetische Spule und/oder eine oder mehr als eine elektrostatische Elektrode auf, wie nachfolgend noch genauer beschrieben wird. Die Betriebsparameter des Stellsystems 134 spannen zusätzliche Dimensionen auf für das Beeinflussen des Materialstroms 116.

**Fig.1B** veranschaulicht Aspekte zur Lichtbogenentladung gemäß verschiedenen Ausführungsformen 100b in einem schematischen Prozessdiagramm, vorzugsweise eingerichtet gemäß Ausführungsform 100b und/oder Beispiel 20, mittels welcher eine Lichtbogenverdampfung (beispielsweise zur Laser-induzierten Lichtbogenverdampfung) erfolgen kann. Anschaulich verbessern diese Aspekte die Eigenschaften der Zwischenschicht und/oder vergrößern den Spielraum bei der Auswahl des Arbeitspunktes (AP) beim Bilden der Zwischenschicht.

Diese Aspekte der Lichtbogenentladung werden können beispielsweise mittels einer Vorrichtung, wie beispielsweise eine Vakuumanordnung und/oder eine Steuervorrichtung, und/oder mittels des Verfahrens implementiert werden. Zum vereinfachten Verständnis wird auf die Implementierung mittels der Vakuumanordnung Bezug genommen, wobei das hierfür Beschriebene in Analogie gelten kann für jede der anderen Implementierungen. Gepulste Signale sind mittels eines Zirkumflex "^" gekennzeichnet. Ferner wird zum vereinfachten Verständnis auf eine Laser-angeregte Lichtbogenentladung Bezug genommen, bei welcher eine Lichtbogenentladung mittels eines Laserpulses angeregt wird. Das hierfür Beschriebe kann verstanden werden als in Analogie geltend für jede andere Art der Plasmaentladung, die nicht notwendigerweise eine Lichtbogenentladung sein muss und/oder nicht notwendigerweise mittels eines Laserpulses angeregt werden muss.

Eine exemplarische Implementierung der Vakuumanordnung (vorzugsweise gemäß Beispiel 42) weist eine Vakuumkammer 102 auf. Die oder jede Vakuumkammer 102 kann optional einen Kammerdeckel aufweisen, welcher das Innere der Vakuumkammer 102 vakuumdicht verschließt. Die Lichtbogenentladung kann dementsprechend einem Prozessdruck (z.B. Vakuumdruck) und/oder einem Prozessgas ausgesetzt sein. Die Vakuumanordnung weist ferner eine Beschichtungsvorrichtung 108 auf. Die Beschichtungsvorrichtung 108 kann eingerichtet sein zur Beschichtung des Substrats 104 unter Verwendung einer Laser-induzierten Lichtbogenentladung.

Der jeweils zum Betreiben der Beschichtungsvorrichtung 108 verwendete Gasdruck (auch als Prozessdruck bezeichnet) und/oder das jeweils der Beschichtungsvorrichtung 108 zugeführte Prozessgas (z.B. ein Gas oder Gasgemisch) kann stark anwendungsabhängig sein. Beispielsweise kann der Prozessdruck in einem Bereich sein von ungefähr $10^{-4}$ mbar (Millibar) bis ungefähr $5 \cdot 10^{-4}$ mbar sein. Beispielsweise kann das Prozessgas eines oder mehr als eines der folgenden Gase aufweisen: Sauerstoff (z.B. molekularer Sauerstoff, d.h. $O_2$), Stickstoff (z.B. molekularer Stickstoff, d.h. $N_2$), Wasserstoff (z.B. molekularer Wasserstoff, d.h. $H_2$), eine oder mehr als eine Kohlenwasserstoffverbindung oder ein Gasgemisch daraus. Das Prozessgas kann das Arbeitsgas (z.B. ein Inertgas) und/oder ein Reaktivgas aufweisen. Das optionale Reaktivgas kann beispielsweise Wasserstoff aufweisen.

Eine exemplarische Implementierung des Beschichtungssystems weist eine Beschichtungsvorrichtung 108, welche einen Targethalter (nicht dargestellt) zum Halten des Targets 112 aufweist. Das Target 112 kann im Allgemeinen ein Verdampfungsgut (z.B. das Beschichtungsmaterial) aufweisen oder daraus bestehen, welches in einen gasförmigen Zustand überführt werden soll. Der Targethalter kann dem Target 112 beispielsweise eine Drehachse bereitstellen und kann eingerichtet sein, das Target 112 (wenn in dem Targethalter gehalten) in eine Drehbewegung um die Drehachse herum zu versetzen, z.B. mittels einer Antriebsvorrichtung. Die Beschichtungsvorrichtung 108 weist optional eine Laserquelle 110 auf.

Eine exemplarische Implementierung der Beschichtungsvorrichtung (vorzugsweise gemäß Beispiel 20) weist die Laserquelle 110 auf, die eingerichtet ist, einen oder mehr als einen Laserpuls 114 (d.h. gepulster Laserstrahl) zu erzeugen und auf den Targethalter, oder zumindest das Targets 112, zu richten.

In einer exemplarischen Implementierung des Betriebs der Vakuumanordnung ist das Target 112 in dem Targethalter gehalten und wird mittels der Laserquelle 110 wiederholt mit einem Laserpuls 114 bestrahlt. Dieser Laserpuls 114 kann eine Lichtbogenentladung an dem Target 112 anregen (z.B. induzieren), bei welcher ein Teil des Targets in Materialdampf überführt wird. Das Target 112 kann hierbei als Kathode betrieben werden. Daher kann der Targethalter auch als Kathode-Endblock bezeichnet werden).

Als Kathode-Endblock (im Folgenden vereinfacht auch als Endblock bezeichnet) kann eine Vorrichtung bezeichnet werden, welche eingerichtet ist, eine Kathode zu halten und zu versorgen, z.B. mit einem Drehmoment zum Drehen der Kathode, mit elektrischer Energie und optional mit einem Kühlfluid. Zum Bereitstellen des Drehmoments kann der Endblock eine Antriebsvorrichtung (z.B. einen Motor) aufweisen oder zumindest mit einer solchen gekuppelt sein. Der Endblock kann im Inneren einer Vakuumkammer befestigt sein, z.B. an einer Durchgangsöffnung in deren Kammerwand (auch als Versorgungsöffnung bezeichnet). Die elektrische Energie und/oder das Kühlfluid (und optional das Drehmoment) können dem Endblock durch die Versorgungsöffnung hindurch zugeführt werden. Optional kann dem Endblock ein oder mehr als ein zusätzliches Medium zugeführt werden, welches zum Versorgen der Kathode dient, z.B. Daten zum Steuern und/oder zum Auslesen eines Sensors.

Eine exemplarische Implementierung des Targets 112 ist rohrförmig (dann auch als Rohrtarget bezeichnet). Das Target 112 kann beispielsweise einen rohrförmigen Träger (ein so genanntes Trägerrohr) aufweisen, auf dem ein (z.B. sprödes und/oder zerbrechliches) Beschichtungsmaterial befestigt sein kann. Der Durchmesser des Rohrtargets kann beispielsweise in einem Bereich sein von ungefähr 10 cm (Zentimeter) bis ungefähr 50 cm, z.B. ungefähr 20 cm oder mehr.

Die Vakuumanordnung kann eine oder mehr als eine elektrische Versorgungsvorrichtung 118 (kann auch als elektrische Leistungsversorgung bezeichnet werden) aufweisen. Jede elektrische Versorgungsvorrichtung 118 kann eingerichtet sein, eine oder mehr als eine Betriebsspannung (z.B. eine Gleichspannung) bereitzustellen, z.B. gepulst (auch als Spannungspuls bezeichnet). Alternativ oder zusätzlich kann die elektrische Versorgungsvorrichtung 118, z.B. pro bereitzustellendem Leistungspuls, beispielsweise einen Pulsgenerator (vorzugsweise eingerichtet gemäß Beispiel 22) aufweisen.

Die Betriebsspannung zwischen der Anode und dem Targethalter angelegt werden. Die anzulegende Betriebsspannung kann anschaulich derart eingerichtet sein, dass sich ein elektrischer Strom zwischen der Anode und der Kathode entladen kann, allerdings noch keine Spontanentladungszündung (unkontrollierter Beginn der Entladung). Dazu kann die Betriebsspannung kleiner sein als die Zündspannung (das heißt, die Spannung, bei der eine Lichtbogenentladung gezündet wird) und größer sein als eine Brennspannung (das heißt, die Spannung, bei der eine Lichtbogenentladung abläuft). Zum Beispiel kann ein Anodenpotential an der Anode in einem Bereich von ungefähr 10 bis ungefähr 20 V liegen. Ein Kathodenpotential an der Kathode kann beispielsweise negativ (z.B. bezüglich elektrischer Masse) sein und/oder dessen Betrag in einem Bereich sein kann von ungefähr 240 V bis ungefähr 350 V liegen.

Eine exemplarische Implementierung der elektrischen Versorgungsvorrichtung 118 ist eingerichtet, einen ersten elektrischen Leistungspuls 120 zu erzeugen. Der erste elektrische Leistungspuls 120 kann an das Target 112 angelegt werden. Der erste elektrische Leistungspuls 120 kann eingerichtet sein zum elektrischen Versorgen der (mittels des Laserpulses 114 induzierten) Lichtbogenentladung (z.B. mittels des Targets 112). Hierzu kann der Targethalter mit der elektrischen Versorgungsvorrichtung 118 elektrisch gekoppelt sein.

Die Vakuumanordnung kann eine Steuervorrichtung 124 aufweisen. Die Steuervorrichtung 124 kann eingerichtet sein zum Steuern der Laserquelle 110. Beispielsweise kann die Steuervorrichtung 124 die Laserquelle 110 ansteuern, um den Laserpuls 114 zu erzeugen und so eine Laser-induzierte Lichtbogenentladung zu initiieren. Die Steuervorrichtung 124 kann eingerichtet sein zum Steuern der elektrischen Versorgungsvorrichtung 118 und/oder der Laserquelle 110. Beispielsweise kann die Steuervorrichtung 124 die elektrische Versorgungsvorrichtung 118 ansteuern, um den ersten elektrischen Leistungspuls 120 gemäß einem (ersten) Soll-Leistungspuls (z.B. einem Soll-Strompuls) zu erzeugen. Der erste elektrische Leistungspuls 120 kann mittels eines von der elektrischen Versorgungsvorrichtung 118 erzeugten (oder gesteuerten) Strompulses vermittelt werden.

Wird hierin auf eine Vorgabe, wie beispielsweise einen Soll-Leistungspuls und/oder Eigenschaften davon (z.B. einen Soll-Leistungspuls, eine Soll-Zeitverzögerung, und/oder eine Soll-Frequenz, etc.), Bezug genommen, so kann dieser mittels Codesegmenten implementiert sein, welche beispielsweise in einem der Steuervorrichtung 124 zugehörigen Datenspeicher abgespeichert sein können. Die Codesegmente können in einer geeigneten Art und Weise in dem Datenspeicher abgespeichert sein, zum Beispiel als Liste (z.B. Tabelle), Wertereihe, als Algorithmus, etc.

Ein durch die Steuervorrichtung 124 durchgeführtes Ansteuern kann gemäß einer Betriebssequenz erfolgen. Diese Betriebssequenz kann in einer geeigneten Art und Weise in dem Datenspeicher abgespeichert sein, zum Beispiel als Algorithmus oder auf andere Weise mittels Codesegmenten.

Eine exemplarische Implementierung der Antriebsvorrichtung ist eingerichtet, eine Drehbewegung des Targets 112 um eine Drehachse herum anzuregen. Zum Beispiel kann der Targethalter hierfür die Antriebsvorrichtung (z.B. einen elektrischen Motor) aufweisen, der eingerichtet ist, dem Target ein Drehmoment zuzuführen. Die Steuervorrichtung 124 kann eingerichtet sein, die Antriebsvorrichtung anzusteuern, um so die Drehbewegung (z.B. eine Drehfrequenz) zu steuern.

Mittels des Lichtbogens kann das (z.B. feste) Target zumindest teilweise (zum Beispiel an dem Entladungspunkt auf dem Target 112) in den gasförmigen Aggregatszustand (vereinfacht auch als gasförmigen Zustand oder als Dampf bezeichnet) überführt werden. Das Überführen kann vereinfacht auch als Verdampfen bezeichnet werden, kann im Allgemeinen aber auch ein Sublimieren (also ein direkter Übergang von dem festen Aggregatszustand des Target-Materials in den gasförmigen Zustand) aufweisen. Das mittels der Lichtbogenentladung aus dem Target 112 herausgelöste (z.B. von dem Target 112 verdampfte) Material kann einen Materialstrom 116 von dem Target 112 weg bilden.

Im Betrieb der Vakuumanordnung kann mittels des Materialstroms 116 ein (oder mehr als ein) Substrat 106 beschichtet werden. Dazu kann die Vakuumanordnung einen Substrathalter 104 aufweisen, der eingerichtet ist, das eine oder mehr als eine Substrat 104 zu halten und/oder zu transportieren (dann auch als Transportvorrichtung 104 bezeichnet). Der Substrathalter 104 kann in der Vakuumkammer 102 angeordnet sein. In verschiedenen Ausgestaltungen kann ein Abstand zwischen der Drehachse und dem Substrathalter in einem Bereich von ungefähr 410 mm bis ungefähr 750 mm liegen.

Eine exemplarische Implementierung der Transportvorrichtung 104 ist eingerichtet ein bandförmiges Substrat (auch als Bandsubstrat bezeichnet) zu transportieren, z.B. von Rolle zu Rolle. Dabei kann die Transportvorrichtung 104 eine erste Rolle halten, von welcher das Bandsubstrat abgewickelt wird, und eine zweite Rolle halten, auf welche das Bandsubstrat aufgewickelt wird, nachdem es dem Materialstrom 116 ausgesetzt wurde.

Eine exemplarische Implementierung der elektrischen Versorgungsvorrichtung 118 ist eingerichtet, einen zweiten elektrischen Leistungspuls 122 zu erzeugen. Der zweite elektrische Leistungspuls 122 kann eingerichtet sein zum Beschleunigen des (z.B. ionisierten Anteils des) Materialstroms 116 von dem Target 112 weg bzw. zu dem Substrathalter 104 hin. Hierzu kann der Substrathalter 104 mit der elektrischen Versorgungsvorrichtung 118 elektrisch gekoppelt sein. Durch den zweiten elektrische Leistungspuls 122 kann eine kinetische Energie, mit der das Material des Materialstroms 116 auf das Substrat 106 trifft, beeinflusse werden.

Gemäß verschiedenen Aspekten können der Laserpuls 114, der erste elektrische Leistungspuls 120 und optional ferner der zweite elektrische Leistungspuls 122, z.B. eine oder mehr als eine Eigenschaft (z.B. Zeitabhängigkeit, Frequenz und/oder Pulsdauer) davon, miteinander verknüpft sein (z.B. mittels der Betriebssequenz), z.B. derart, dass diese zeitlich einander überlappen. Hierzu kann die Steuervorrichtung 124 beispielsweise einen Taktgeber aufweisen, welcher eine Verknüpfung des Laserpulses 114, des ersten elektrischen Leistungspulses 120 und optional ferner des zweiten elektrischen Leistungspulses 122 miteinander implementiert.

Gemäß verschiedenen Aspekten kann das Substrat 106 beschichtet werden, indem wiederholt (gemäß einer Soll-Frequenz) eine jeweilige Lichtbogenentladung mit zugehörigem Materialstrom 116 (auch als Entladungszündung bezeichnet) erzeugt wird. Als Entladungszündung wird hierin das (beispielsweise wiederholte) Anregen der Lichtbogenentladung mittels eines oder mehr als eines Pulses verstanden, beispielsweise mittels des Laserpulseses 114 und mittels des ersten elektrischen Leistungspulses 120. Pro Entladungszündung kann der Laserpuls 114, der erste elektrische Leistungspuls 120 und optional der zweite elektrische Leistungspuls 122 erzeugt werden.

Die hierin beschriebene Versorgungsvorrichtung 118 kann ebenso mittels einer oder mehr als einer einzelnen Vorrichtung implementiert werden, wovon beispielsweise eine erste Vorrichtung den ersten Leistungspuls und eine zweite Vorrichtung den zweiten Leistungspuls erzeugt.

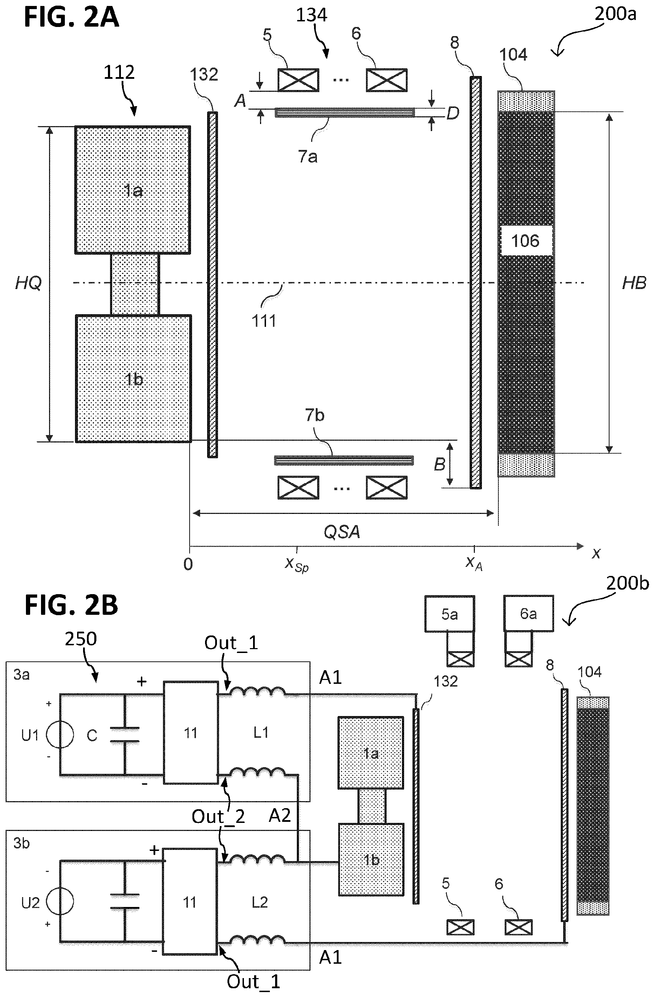

**Fig.2A** veranschaulicht das Beschichtungssystem gemäß verschiedenen Ausführungsformen 200a in einer schematischen Seitenansicht oder Querschnittsansicht, vorzugsweise eingerichtet gemäß Ausführungsformen 100a bis 100b und/oder gemäß Beispiel 2.

Eine exemplarische Implementierung des kapazitiven Stellglieds des Stellsystems 134 weist eine Elektrode 8 (auch als Stellelektrode bezeichnet) auf zum Erzeugen des elektrischen Feldes, welche als Anode (dann auch als Stellanode bezeichnet) eingerichtet ist.

Eine exemplarische Implementierung des induktives Stellglieds (vorzugsweise gemäß Beispiel 3) des Stellsystems 134 weist mehrere entlang Emissionsachse 111 hintereinander angeordnete elektromagnetische Spulen 5, 6 auf, z.B. zwei oder mehr elektromagnetische Spulen 5, 6, zum Erzeugen des magnetischen Feldes. Jede der Spulen weist mehrere Windungen um die Emissionsachse 111 herum auf, so dass die Spule entlang der Emissionsachse 111 von dem Ausbreitungsraum (vorzugsweise gemäß Beispiel 14) durchdrungen ist.

Optional weist das induktive Stellglied (vorzugsweise gemäß Beispiel 3) mehrere magnetisierbare (z.B. ferromagnetische und/oder weichmagnetische) Wände 7a, 7b (z.B. Platten) als Shimvorrichtung auf, zwischen denen die Emissionsachse 111 angeordnet ist und welche sich in eine oder mehr als eine der Spulen 5,6 hinein erstrecken.

Eine exemplarische Implementierung des Targets 112 weist mehrere Segmente 1a, 1b auf, zwischen denen das Target 112 verjüngt ist. Dies verbessert die Plasmaausbreitung.

Nachfolgend werden exemplarische Implementierung der Geometrie (auch als bezeichnet) Geometriebeispiele des Beschichtungssystems erläutert, welche den Beschichtungsprozess verbessern:

Gemäß Geometriebeispiel 1 ist Substrat 106 in einem Abstand QSA (auch als Quelle-Substrat-Abstand bezeichnet) von dem Target 112 angeordnet; das induktive Stellglied in einem Abstand xSP von dem Target 112 angeordnet und das kapazitive Stellglied in einem Abstand xA von dem Target 112 angeordnet. Ferner kann eine oder mehr als eine der folgenden Relationen erfüllt sein:

$$QSA > xA > xSP;$$

und/oder

$$QSA - xA > xSP.$$

Gemäß Geometriebeispiel 2 ist eine Ausdehnung D jeder der Wände (auch als Wanddicke D bezeichnet) in Richtung von der Emissionsachse 111 weg größer als 1 mm, z.B. als 5 mm, z.B. als 10 mm, z.B. als 20 mm (Millimeter). Alternativ oder zusätzlich ist ein Abstand A jeder der Wände von den Windungen jeder Spule größer sein als die Wanddicke D.

Gemäß Geometriebeispiel 3 ist eine Referenzrichtung (z.B. Gravitationsrichtung 105) quer zur Emissionsachse 111 und/oder entlang der Drehachse des Targets 112 (und/oder des Substrathalters 104). Entlang der Referenzrichtung weist das Target eine Ausdehnung HQ (auch als Targethöhe bezeichnet) auf; das kapazitive Stellglied 8 (oder die Passage) eine Ausdehnung T = HQ + B auf; und das Substrat eine Ausdehnung HB auf. Ferner kann eine oder mehr als eine der folgenden Relationen erfüllt sein:

$$B > 0$$

(auch als Überstand B bezeichnet);

$$T > HB \text{ und/oder } T > HQ;$$

$$HB > HQ.$$

Der Überstand verbessert anschaulich den Beschichtungsprozess.

Gemäß Geometriebeispiel 4 ist eine oder mehr als eine der folgenden Relationen erfüllt:

$$T > QSA \text{ und/oder } HB > QSA;$$

$$B > D \text{ und/oder } B > A;$$

$$HQ > QSA.$$

Gemäß Geometriebeispiel 5 ist eine Querrichtung quer zur Emissionsachse 111 und quer zur Referenzrichtung (z.B. Gravitationsrichtung 105). Entlang der Querrichtung weist das Target eine Ausdehnung B_T (auch als Targetbreite bezeichnet) auf; das kapazitive Stellglied 8 (oder die Passage) eine Ausdehnung B_A auf; und das Substrat eine Ausdehnung B_S auf. Ferner kann eine oder mehr als eine der folgenden Relationen erfüllt sein:

$$B\_A > B\_S \text{ und/oder } B\_A > B\_T;$$

$$B\_T > B\_S.$$

Dies verbessert anschaulich den Beschichtungsprozess.

**Fig.2B** veranschaulicht das Beschichtungssystem gemäß verschiedenen Ausführungsformen 200b in einem schematischen Verschaltungsplan, vorzugsweise eingerichtet gemäß Ausführungsformen 100a bis 200a und/oder gemäß Beispiel 22.

Eine exemplarische Implementierung der Versorgungsvorrichtung 118 weist mehrere Generatoren 3a, 3b auf, wovon jeder Generator als Pulsgenerator eingerichtet ist, und zwei ausgangsseitige Anschlüsse A1, A2 aufweist. Nachfolgend werden verschiedene exemplarische Implementierungen eines Generators (auch als Generatorbeispiele bezeichnet) der Versorgungsvorrichtung 118 beschrieben, wobei das Beschriebene vorzugsweise für jeden der Generatoren 3a, 3b gelten kann. Hierzu kann verstanden werden, dass der Generator oder zumindest die Versorgungsvorrichtung 118 auch einzeln bereitgestellt werden können.

Gemäß Generatorbeispiel 1 ist ein erster Anschluss A1 (auch als ausgangsseitiger Anodenanschluss bezeichnet) der zwei Anschlüsse des Generators mit einer Anode (z.B. der Anode 132 oder der Hilfsanode) elektrisch gekoppelt, um der Anode einen Leistungspuls zuzuführen.

Gemäß Generatorbeispiel 2 ist ein zweiter Anschluss A2 (auch als ausgangsseitiger Kathodenschluss bezeichnet) der zwei Anschlüsse des Generators mit dem Targethalter elektrisch gekoppelt, um zwischen dem Anodenanschluss A1 und dem Targethalter die Betriebsspannung bereitzustellen. Sind zwei Generatoren vorhanden, können deren ausgangsseitigen Kathodenschlüsse beispielsweise ohmsch miteinander gekoppelt sein.

Gemäß Generatorbeispiel 3 weist der Generator, pro Anschluss der zwei Anschlüsse A1, A2, einen Schaltkreis auf, dessen Ausgangsknoten mittels einer elektromagnetischen Spule L1, L2 mit dem Anschluss gekoppelt ist. Jeder Schaltkreis kann beispielsweise mittels einer Brückenschaltung 11, z.B. einer H-Brückenschaltung 11 (auch als H-Brücke bezeichnet), bereitgestellt sein, wie später noch genauer erläutert wird.

Gemäß Generatorbeispiel 4 weist die Leistungsquelle 250 des Generators eine Leistungsquelle U1, U1 (z.B. ein Netzteil) auf, welches eingerichtet ist, eine Gleichspannung bereitzustellen, z.B. die Betriebsspannung. Die Leistungsquelle kann beispielsweise einen Wandler (z.B. Netzteil) aufweisen, welches eingerichtet ist, eine Wechselspannung (z.B. Netzspannung eines öffentlichen Stromnetzes) in die Gleichspannung zu überführen.

Gemäß Generatorbeispiel 5 weist die Leistungsquelle 250 des Generators einen kapazitiven Leistungsspeicher auf, beispielsweise mittels eines oder mehr als eines Kondensators implementiert. Der kapazitiven Leistungsspeicher kann beispielsweise eine Kapazität C aufweisen.

Ferner weist die Versorgungsvorrichtung 118, pro Spule des elektromagnetischen Stellglieds, eine Gleichstromquelle 5a, 6a auf zum Versorgen der Spule mit einem Gleichstrom.

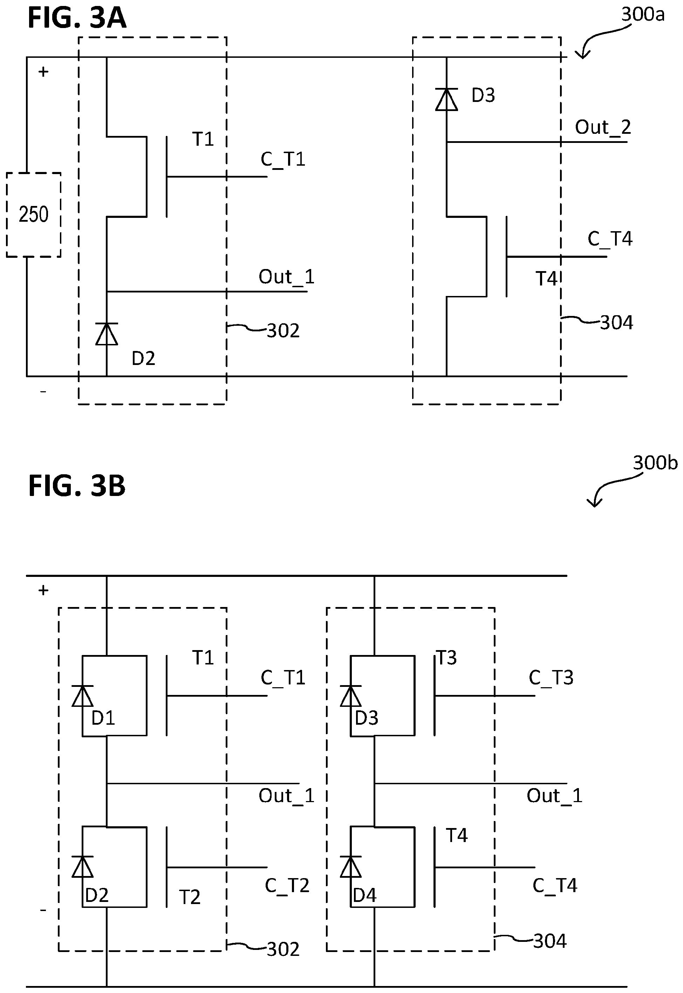

**Fig.3A** veranschaulicht einen Generator gemäß verschiedenen Ausführungsformen 300a in einem schematischen Verschaltungsplan, vorzugsweise eingerichtet gemäß Ausführungsformen 100a bis 200b und/oder gemäß Beispiel 24.

Gemäß Generatorbeispiel 6 ist der erste Anschluss A1 des Generators mittels einer ersten Spule mit einem ersten Schaltkreis 302 (z.B. dessen Ausgangsknoten Out_1) gekoppelt und der zweite Anschluss A2 des Generators mittels einer zweiten Spule mit einem zweiten Schaltkreis 304 (z.B. dessen Ausgangsknoten Out_2) gekoppelt.

Gemäß Generatorbeispiel 7 weist der Generator zwei Schaltkreise 302, 304 auf, welche parallel zueinander geschaltet sind und/oder wovon jeder Schaltkreis zwischen die zwei Ausgänge (+,-) der Leistungsquelle 250 geschaltet ist. Nachfolgend werden verschiede exemplarische Implementierungen eines Schaltkreises (auch als Schaltkreisbeispiele bezeichnet) des Generators beschrieben, wobei das Beschriebene vorzugsweise für jeden der Schaltkreise 304 gelten kann.

Gemäß Schaltkreisbeispiel 1 ist ein oder mehr als ein Schalter T1, T4 des Schaltkreises auf, welcher mittels eines Bipolartransistors mit isolierter Gate-Elektrode (IGBT) implementiert ist.

Gemäß Schaltkreisbeispiel 2 ist ein oder mehr als ein Schalter T1, T4 des Schaltkreises mit einem Steuereingang C_T1, C_T4 des Schaltkreises gekoppelt und eingerichtet, mittels eines an dem Steuereingang anliegenden Steuersignals geschaltet zu werden. Das Steuersignal kann beispielsweise mittels der Steuervorrichtung erzeugt werden.

Gemäß Schaltkreisbeispiel 3 sind die Freilaufdiode D2 und der Schalter T1 des Schaltkreises in Reihe zueinander und/oder mittels des Ausgangsknotens Out_1, Out_2 miteinander gekoppelt.

Gemäß Schaltkreisbeispiel 4 ist pro Ausgang des Generators ein Schaltkreis 302, 304 vorhanden, dessen Ausgangsknoten Out_1, Out_2 mittels einer elektrischen Spule L mit dem Ausgang des Generators gekoppelt ist.

**Fig.3B** veranschaulicht einen Generator gemäß verschiedenen Ausführungsformen 300b in einem schematischen Verschaltungsplan, vorzugsweise eingerichtet gemäß Ausführungsformen 100a bis 300a und/oder gemäß Beispiel 22. Der Generator weist eine H-Brückenschaltung auf, welche die zwei Schaltkreise bereitstellt.

Gemäß Schaltkreisbeispiel 5 weist der Schaltkreis zwei Baugruppen aus Schalter Ti und Freilaufdiode Di (i=,1,2,3,4), wobei die zwei Baugruppen in Reihe zueinander und mittels eines Ausgangsknotens miteinander gekoppelt sind. Jede der Baugruppen weist einen Schalter Ti und eine Freilaufdiode Di auf, welche parallel zueinander geschaltet sind.

Die H-Brückenschaltung stellt somit eine geschlossene Masche bereit, entlang welcher vier Baugruppen in Reihe hintereinander geschaltet sind, und welche die zwei Ausgangsknoten aufweist, an denen ein Ausgang abgezweigt wird. Die H-Brückenschaltung ermöglicht eine kostengünstige Implementierung des Generators.

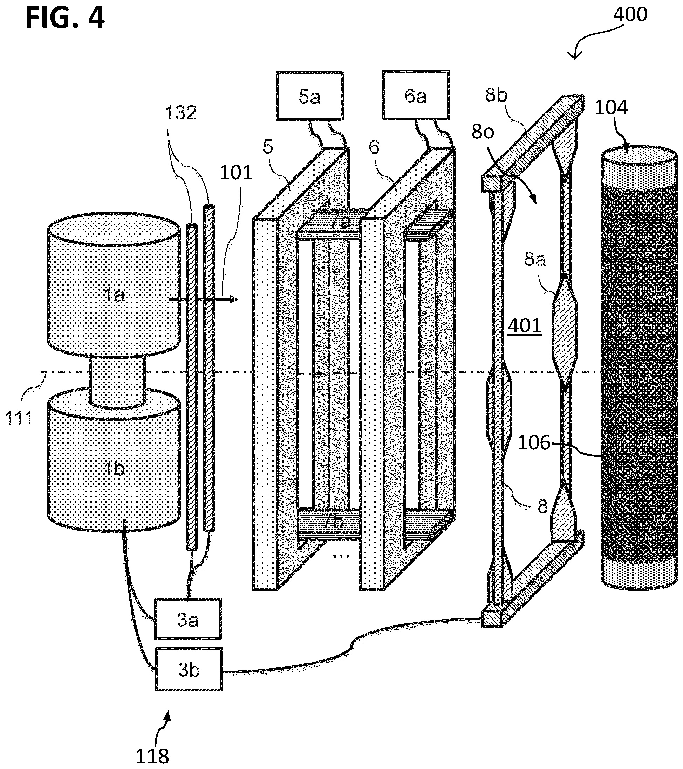

**Fig.4** veranschaulicht das Beschichtungssystem gemäß verschiedenen Ausführungsformen 400 in einer schematischen Perspektivansicht, vorzugsweise eingerichtet gemäß Ausführungsformen 100a bis 300b und/oder gemäß Beispiel 6.

Eine exemplarische Implementierung der Stellelektrode 8 (vorzugsweise gemäß Beispiel 7) weist vier Elektrodenbalken 8a, 8b auf, welche einen Rahmen bilden. Die Elektrodenbalken 8a, 8b umlaufen eine Durchgangsöffnung 8o, von welcher die Stellelektrode 8 durchdrungen ist. Zwei der Elektrodenbalken 8a, 8b sind jeweils auf einander gegenüberliegenden Seiten der Durchgangsöffnung 8o angeordnet. Der Ausbreitungsraum 401 (vorzugsweise gemäß Beispiel 14) kann sich entlang der Emissionsrichtung 101 von dem Target 1 durch die Durchgangsöffnung 8o hindurch erstrecken.

Eine exemplarische Implementierung der Anode 132 weist zwei Balken auf, welche auf einander gegenüberliegenden Seiten des Ausbreitungsraums 401 angeordnet sind.

Eine exemplarische Implementierung der Versorgungsvorrichtung 118 weist zwei Generatoren 3a, 3b auf. Ein erster Generator 3a der zwei Generatoren 3a, 3b ist als Pulsgenerator eingerichtet und eingerichtet, der Anode 132 elektrische Leistung (z.B. gepulst) zuzuführen. Dazu kann der Anodenanschluss A1 des erster Generators 3a mit der Anode 132 ohmsch gekoppelt sein. Ein zweiter Generator 3b der zwei Generatoren 3a, 3b ist als Pulsgenerator eingerichtet und eingerichtet, der Stellelektrode 8 elektrische Leistung (z.B. gepulst) zuzuführen. Dazu kann der Anodenanschluss A1 des zweiten Generators 3b mit der Stellelektrode 8 ohmsch gekoppelt sein. Ferner kann der Kathodenschluss A2 jedes Generators der der zwei Generatoren 3a, 3b mit dem Targethalter (oder zumindest dem Target) gekoppelt sein.

Eine exemplarische Implementierung der Versorgungsvorrichtung 118 weist pro Spule 5, 6 des elektromagnetischen Stellglieds, eine Gleichstromquelle 5a, 6a auf zum Versorgen der Spule 5, 6 mit einem Gleichstrom.

**Patentansprüche**

1. Beschichtungssystem zum Beschichten eines Substrats mittels einer Bogenentladung, aufweisend:

- einen Targethalter (112h) zum Halten eines Targets;
- einen entlang einer Emissionsachse (111) hinter dem Targethalter (112h) angeordneten Substrathalter (104) zum Halten eines mittels des Targets (112h) zu beschichtenden Substrats;
- eine Anode (132) zum Erzeugen einer zwischen dem Target (112) und der Anode (132) vermittelten Bogenentladung, wobei die Anode (132) zwischen dem Targethalter (112h) und dem Substrathalter (104) angeordnet ist;
- ein entlang der Emissionsachse (111) hinter der Anode (132) angeordnetes induktives Stellglied (134), welches eine oder mehr als eine elektromagnetischen Spule aufweist und eingerichtet ist, mittels der Spule ein magnetisches Feld zu erzeugen zum Beeinflussen eines mittels der Bogenentladung erzeugten und sich von dem Targethalter (112h) entlang der Emissionsachse (111) ausbreitenden Plasmas.

2. Beschichtungssystem gemäß Anspruch 1, ferner aufweisend: ein kapazitives Stellglied zum Erzeugen eines elektrischen Feldes, welches entlang Emissionsachse (111) hinter der Anode (132) angeordnet ist, vorzugsweise zwischen dem induktiven Stellglied (134) und dem Substrathalter (104).

3. Beschichtungssystem gemäß Anspruch 2, wobei das kapazitive Stellglied rahmenförmig ist und entlang der Emissionsachse (111) von einer Durchgangsöffnung durchdrungen ist.

4. Beschichtungssystem gemäß einem der Ansprüche 2 bis 3, wobei das kapazitive Stellglied eine größere Ausdehnung aufweist als die Anode (132).

5. Beschichtungssystem gemäß einem der Ansprüche 2 bis 4, wobei das kapazitive Stellglied ein oder mehr als ein Paar Balken aufweist, zwischen denen die Emissionsachse (111) hindurch verläuft, welche einen größeren Abstand voneinander aufweisen als zwei Träger der Anode (132).

6. Beschichtungssystem gemäß einem der Ansprüche 2 bis 5, wobei das kapazitive Stellglied eine Beschichtung aufweist, welche Titan oder einen Nitrid aufweist oder daraus besteht.

7. Beschichtungssystem gemäß einem der Ansprüche 2 bis 6, wobei das induktive Stellglied und das kapazitive Stellglied ein Stellsystem (134) bereitstellen, das eingerichtet ist, das magnetisches Feld und das elektrisches Feld zu erzeugen, welche einander überlagern.

8. Beschichtungssystem gemäß einem der Ansprüche 1 bis 7, wobei die eine oder mehr als eine elektromagnetischen Spule zwei Spulen aufweist, welche entlang der Emissionsachse (111) hintereinander angeordnet sind.

9. Beschichtungssystem gemäß einem der Ansprüche 1 bis 8, das induktive Stellglied ferner zwei magnetisierbare Segmente aufweisend, wovon jedes Segment entlang der Emissionsachse (111) erstreckt ist und zwischen der Anode (132) und dem Substrathalter (104) innerhalb der einen oder mehr als einen Spule angeordnet ist, wobei zwischen den zwei Segmenten die Emissionsachse (111) angeordnet ist.

10. Beschichtungssystem gemäß einem der Ansprüche 1 bis 9, ferner einen Laser aufweisend, der eingerichtet ist, einen Laserstrahl auf das Targethalter (112h) zu richten zum Anregen der Bogenentladung.

11. Beschichtungssystem gemäß Anspruch 1 bis 10, ferner eine Steuervorrichtung aufweisend, welche eingerichtet ist zum Beeinflussen eines mittels der Bogenentladung durchgeführten Beschichtungsprozesses mittels Veränderns einer elektrischen Spannung, mittels welcher dem induktiven Stellglied elektrische Leistung zugeführt wird, basierend auf einem Zustand des Beschichtungsprozesses.

12. Beschichtungssystem gemäß einem der Ansprüche 1 bis 11, ferner einen oder mehr als einen elektrischen Generator (3a, 3b) aufweisend, wovon jeder Generator aufweist:

- eine elektrische Leistungsquelle zum Bereitstellen elektrischer Leistung,
- einen oder mehr als einen Schaltkreis (302, 304),

wovon jeder Schaltkreis (302, 304) aufweist:

- einen Ausgangsknoten (Out_1, Out_2) zum Abgeben der elektrischen Leistung an das an den Generator angeschlossene Stellglied;
- einen Schalter (T1), welcher die elektrische Leistungsquelle ausgangsseitig mit dem Ausgangsknoten (Out_1, Out_2) koppelt;
- eine Freilaufdiode (D2), welche in Reihe zu dem Schalter ist und die elektrische Leistungsquelle eingangsseitig mit dem Ausgangsknoten (Out_1, Out_2) koppelt.

13. Beschichtungssystem gemäß Anspruch 12, wobei der eine oder mehr als eine Schaltkreis (302, 304) zwei Schaltkreise aufweist, wovon jeder Schaltkreis mittels einer Brückenschaltung bereitgestellt ist, welche die Freilaufdiode und den Schalter aufweist.

**14.** Beschichtungssystem gemäß Anspruch 12 oder 13, wobei jeder Schaltkreis (302, 304) ferner eine elektromagnetische Spule aufweist, welche mittels des Ausgangsknotens (Out_1, Out_2) mit dem Schalter gekoppelt ist und einen elektrischen Anschluss mit dem Ausgangsknoten (Out_1, Out_2) koppelt.

**15.** Beschichtungssystem gemäß einem der Ansprüche 12 bis 14, wobei der eine oder mehr als eine Generator zwei Generatoren aufweist, das Beschichtungssystem ferner einen dritten Anschluss zum Anschließen des Targethalters (112h) aufweisend, mittels welchem die zwei Generatoren ausgangsseitig miteinander gekoppelt sind.

## FIG. 1A

## FIG. 1B

**FIG. 2A**

**FIG. 2B**

## FIG. 3A

300a

## FIG. 3B

300b

# FIG. 4

Europäisches
Patentamt

European
Patent Office

Office européen
des brevets

## EUROPÄISCHER RECHERCHENBERICHT

Nummer der Anmeldung

EP 25 18 6533

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DE 10 2006 009160 A1 (FRAUNHOFER GES FORSCHUNG [DE]) 30. August 2007 (2007-08-30) * Abbildung 3 * * Ansprüche 1-9 * * Absatz [0001] * * Absatz [0011] - Absatz [0016] * * Absatz [0031] * * Absatz [0036] * ----- | 1-10 | INV. H01J37/32 C23C14/32 |
| X | US 6 261 421 B1 (MEUNIER JEAN-LUC [CA] ET AL) 17. Juli 2001 (2001-07-17) * Abbildung 1 * * Spalte 5, Zeile 65 - Spalte 6, Zeile 20 * ----- | 1,8 | |
| X | CN 112 359 330 A (JIANGSU XCMG ENGINEERING MACHINERY RES INSTITUTE CO LTD) 12. Februar 2021 (2021-02-12) * Abbildungen 1-3 * * Absatz [0037] - Absatz [0058] * ----- | 1,8, 11-15 | |

RECHERCHIERTE SACHGEBIETE (IPC)

H01J
C23C

Der vorliegende Recherchenbericht wurde für alle Patentansprüche erstellt

| Recherchenort | Abschlußdatum der Recherche | Prüfer |
|---|---|---|
| Den Haag | 3. November 2025 | Hochstrasser, M |

**ANHANG ZUM EUROPÄISCHEN RECHERCHENBERICHT
ÜBER DIE EUROPÄISCHE PATENTANMELDUNG NR.**

EP 25 18 6533

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

03-11-2025

| Im Recherchenbericht angeführtes Patentdokument | Datum der Veröffentlichung | Mitglied(er) der Patentfamilie | Datum der Veröffentlichung |
|---|---|---|---|
| DE 102006009160 A1 | 30-08-2007 | DE 102006009160 A1<br>EP 1826810 A2<br>US 2007209934 A1 | 30-08-2007<br>29-08-2007<br>13-09-2007 |
| US 6261421 B1 | 17-07-2001 | CA 2256847 A1<br>US 6261421 B1 | 22-06-2000<br>17-07-2001 |
| CN 112359330 A | 12-02-2021 | KEINE | |

Für nähere Einzelheiten zu diesem Anhang : siehe Amtsblatt des Europäischen Patentamts, Nr.12/82

EPO FORM P0461